# EUROPÄISCHE PATENTANMELDUNG

(11) **EP 1 679 746 A2**
(43) Veröffentlichungstag der Anmeldung: **12.07.2006**
(21) Anmeldenummer: 05028062.7
(22) Anmeldetag: 21.12.2005
(51) Int. Cl.: H01L 27/02

(54) **Vorrichtung, Anordnung und System zum ESD-Schutz**

(30) Priorität: 05.01.2005 DE 102005000801
(71) Anmelder: Infineon Technologies AG, 81669 München (DE)
(72) Erfinder: Gossner, Harald, Dr.-Ing., 85521 Riemerling (DE)
(74) Vertreter: Banzer, Hans-Jörg

(57) **Zusammenfassung**

Eine ESD-Schutz-Vorrichtung (19), welche eine herkömmliche Thyristor-Schaltung umfasst, erhöht im ESD-Fall insbesondere mittels eines Schalters (4) einen Widerstand (11) der ESD-Schutz-Vorrichtung (19) im Vergleich zu einem Nicht-ESD-Fall. Eine ESD-Schutz-Anordnung (53) umfasst mindestens eine ESD-Schutz-Vorrichtung (19), so dass die ESD-Schutz-Anordnung (53) insbesondere mit mehreren Spannungspotenzialen (V_{DD1}, V_{DD2}) arbeitende Schaltungen vor elektrostatischen Entladungen schützen kann. Ein ESD-Schutz-System (55) umfasst mindestens eine ESD-Schutz-Anordnung (53), welcher ein ESD-Signal (6') über einen Bus (41) des ESD-Schutz-Systems (55) zugeführt wird. Durch eine geschickte Anordnung von Halbleiterstrukturen lässt sich die ESD-Schutz-Vorrichtung (19) sowie die ESD-Schutz-Anordnung (53) und damit das ESD-Schutz-System (55) sehr kompakt entwerfen.

## Beschreibung

Die vorliegende Erfindung betrifft eine ESD-Schutz-Vorrichtung, eine ESD-Schutz-Anordnung und ein ESD-Schutz-System, um vorzugsweise eine mikroelektronische Schaltung bzw. Halbleiterschaltung vor einer elektrostatischen Entladung zu schützen. Außerdem betrifft die vorliegende Erfindung eine Halbleiterschaltung, welche die ESD-Schutz-Vorrichtung oder die ESD-Schutz-Anordnung oder das ESD-Schutz-System umfasst.

Steuerbare Gleichrichter bzw. Thyristoren sind weit verbreitete und sehr erfolgreiche Schutzvorrichtungen vor elektrostatischen Entladungen (ESD-Fall). Ein Vorteil von Thyristoren ist, dass sie eine sehr hohe Stromdichte vertragen, bevor eine Beschädigung des Thyristors bei einem ESD-Fall auftritt, wobei der ESD-Fall vorliegt, wenn es zu einer elektrostatischen Entladung kommt. Außerdem halten Thyristoren eine an ihnen anliegende Spannung auch unter Bedingungen eines hohen Stromflusses konstant. Damit bieten die Thyristoren einen guten Schutz für eine zu schützende Schaltung gegenüber dem ESD-Fall.

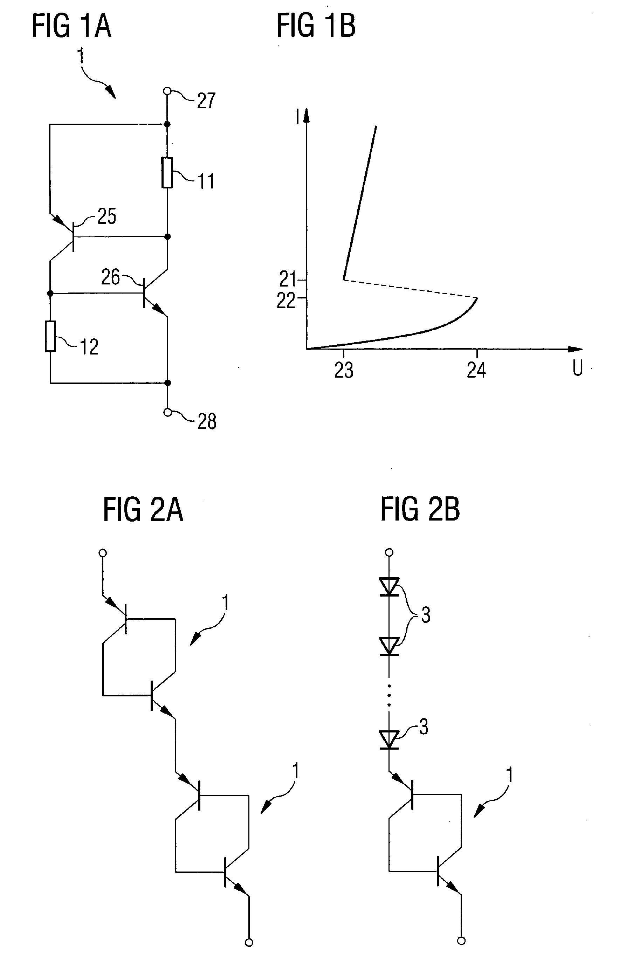

Eine Thyristor-Schaltung 1 bzw. ESD-Schutz-Vorrichtung nach dem Stand der Technik ist in Fig. 1a dargestellt. Dabei ist ein erster Anschluss 27 der Thyristor-Schaltung 1 mit dem Emitter eines PNP-Transistors 25 und über einen n-Wannen-Widerstand 11 mit der Basis des PNP-Transistors 25 und mit dem Kollektor eines NPN-Transistors 26 verbunden. Der Kollektor des PNP-Transistors 25 ist mit der Basis des NPN-Transistors 26 und über einen p-Wannen-Widerstand 12 mit einem zweiten Anschluss 28 der Thyristor-Schaltung 1 verbunden. Der Emitter des NPN-Transistors 26 ist ebenfalls mit dem zweiten Anschluss 28 verbunden.

Die Funktionsweise der in Fig. 1a dargestellten Thyristor-Schaltung 1 wird mit Hilfe einer Strom-Spannungs-Kennlinie der Fig. 1b erläutert. Tritt zwischen den Anschlüssen 27, 28 der Thyristor-Schaltung 1 eine Spannung auf, welche höher als eine Schaltspannung 24 ist, kommt die Thyristor-Schaltung 1 in einen niederohmigen Bereich, welcher bei einem durch eine Haltespannung 23 und einen Haltesrom 21 gekennzeichneten Punkt beginnt, wodurch der Strom durch die Thyristor-Schaltung 1 stark ansteigt. Dadurch ist die Thyristor-Schaltung 1 in der Lage, die Energie einer elektrostatischen Entladung abzuleiten, so dass diese Energie die zu schützende Schaltung nicht beschädigt. Nach dem Ableiten dieser Energie sollte die an der Thyristor-Schaltung 1 anliegende Spannung unterhalb der Haltespannung 23 fallen bzw. der durch die Thyristor-Schaltung 1 fließende Strom unter den Haltestrom 21 fallen, so dass die Thyristor-Schaltung 1 wieder in einen hochohmigen Bereich kommt bzw. zurückfällt.

Es gibt zwei kritische Probleme bei Thyristor-Schaltungen nach dem Stand der Technik. Erstens besitzen sie oft eine sehr hohe Schaltspannung 24, was dazu führt, dass die zu schützende Schaltung beschädigt wird, bevor der Thyristor den Durchlassbereich (Bereich, in welchem der Thyristor 1 niederohmig ist) erreicht. Zweitens kann die Haltespannung 23 des Thyristors 1 in einem Bereich liegen, in welchem auch die Betriebsspannung der zu schützenden Schaltung liegt. Dabei begrenzt die Haltespannung den Durchlassbereich nach unten (siehe Fig. 1b). Wenn die an dem Thyristor 1, welcher im Durchlassbereich betrieben wird, anliegende Spannung nicht unter die Haltespannung fällt, verbleibt der Thyristor 1 im Durchlassbereich, was nicht erwünscht ist, da dabei Fehlfunktionen oder sogar eine Zerstörung der zu schützenden Schaltung auftreten können. Das zweite Problem ist gerade bei zu schützenden Schaltungen, welche mit 3 bis 5 Volt oder höher betrieben werden, nachteilig.

Um das zweite Problem, welches auch als Latching bezeichnet wird, zu lösen, sind nach dem Stand der Technik mehrere Lösungen bekannt. Zum einen können zwei oder mehrere Thyristoren hintereinander geschaltet werden (siehe Fig. 2a) und zum anderen können mehrere vorwärts vorgespannte Dioden in Serie vor den Thyristor geschaltet werden (siehe Fig. 2b).

Diese Lösungsansätze nach dem Stand der Technik führen jedoch zu einem höheren Widerstand, wenn der Thyristor im Durchlassbereich betrieben wird, was für die zu schützende Schaltung nachteilig ist, da durch die Schaltung im ESD-Fall dann ein höherer Strom fließt. Außerdem benötigen diese Lösungsansätze mehr Bauteile, weshalb sie, wenn sie als Halbleiterbauelemente ausgebildet werden, einen größeren Flächenbedarf aufweisen.

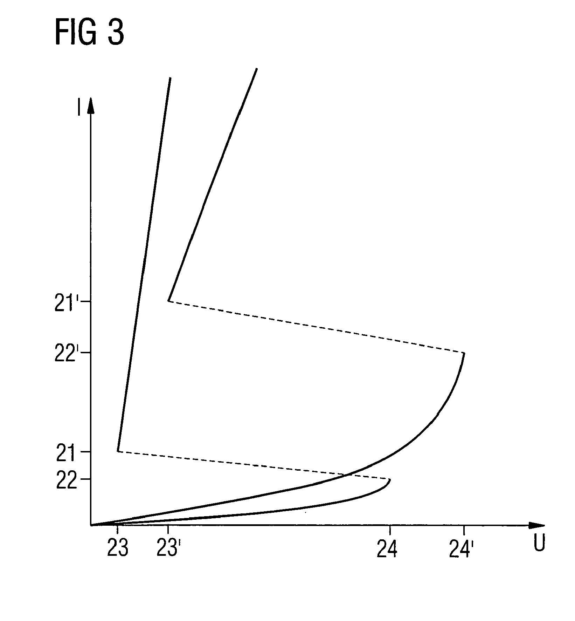

In Fig. 3 ist eine Strom-Spannungs-Kennlinie für die vorab diskutierten Lösungsansätze nach dem Stand der Technik dargestellt (siehe Fig. 2). Man erkennt, dass im Vergleich zu der in Fig. 1a dargestellten Thyristor-Schaltung 1, deren Strom-Spannungs-Kennlinie in Fig. 1b und zum Vergleich ebenfalls in Fig. 3 dargestellt ist, eine höhere Schaltspannung 24' und auch ein höherer Schaltstrom 22' vorliegen, wodurch die schützende Wirkung beeinträchtigt wird.

Ein weiterer Lösungsansatz nach dem Stand der Technik besteht darin, den Auslösestrom und damit auch den Haltestrom des Thyristors anzuheben. Wenn Systemvoraussetzungen für die schützende Schaltung gegeben sind, dass ein bestimmter maximaler Stromwert nicht überschritten werden kann und dieser Stromwert unter dem Haltestrom liegt, kann dadurch ein Latching vermieden werden. Jedoch besitzt dieser Lösungsansatz den Nachteil, dass der Thyristor bei ESD-Fällen mit kleinen oder sogar mittleren Spannungsausschlägen nicht zündet, so dass kein ausreichender Schutz für die zu schützende Schaltung vorliegt. Außerdem gibt es bestimmte zu schützende Schaltungen, bei welchen die Systemvoraussetzungen keinen maximalen Stromwert begrenzen, weshalb für diese Schaltungen dieser Lösungsansatz nicht durchführbar ist.

Deshalb ist es eine Aufgabe der vorliegenden Erfindung einen ESD-Schutz bereitzustellen, bei welchem die vorab beschriebenen Probleme und Nachteile nicht auftreten bzw. nicht vorliegen.

Erfindungsgemäß wird dieser ESD-Schutz durch eine ESD-Schutz-Vorrichtung nach Anspruch 1, eine ESD-Schutz-Anordnung nach Anspruch 16, ein ESD-Schutz-System nach Anspruch 26 sowie durch eine Halbleiterschaltung nach Anspruch 31, 32 oder 33 bereitgestellt. Die abhängigen Ansprüche definieren bevorzugte und vorteilhafte Ausführungsformen der Erfindung.

Im Rahmen der vorliegenden Erfindung wird eine ESD-Schutz-Vorrichtung bereitgestellt, welche zwischen eine erste Leitung und eine zweite Leitung zu schalten ist und einen Thyristor umfasst, welcher ebenfalls mit der ersten und zweiten Leitung zu verbinden ist. Dabei ist der ESD-Schutz-Vorrichtung ein ESD-Signal zuführbar, welches zwei unterschiedliche Werte bzw. Potenziale aufweisen kann. Bei einem ESD-Fall, d. h. beim Auftreten einer elektrostatischen Entladung, weist das ESD-Signal ein anderes Potenzial auf, als wenn kein ESD-Fall vorliegt. Wenn die ESD-Schutz-Vorrichtung durch das ESD-Signal den ESD-Fall erfasst, erhöht die ESD-Schutz-Vorrichtung einen Widerstand der ESD-Schutz-Vorrichtung im Vergleich zu einem Fall, bei welchem der ESD-Fall nicht vorliegt.

Indem der Widerstand der ESD-Schutz-Vorrichtung erhöht wird, wird ein Durchschlagen des Thyristors zusätzlich angeregt, d. h. durch die anfängliche Erhöhung des Widerstands, insbesondere des n-Wannen-Widerstands oder des p-Wannen-Widerstands des Thyristors, wird der Thyristor in einen Zustand versetzt, in welchem der so genannte Thyristoreffekt auch unter einer geringen Schaltspannung und/oder einem geringen Schaltstrom auftritt. Da außerdem der Widerstand wieder verringert wird, wenn über das ESD-Signal signalisiert wird, dass der ESD-Fall nicht (mehr) vorliegt, wird außerdem das Latching vermieden. Das heißt, indem der Widerstand des Thyristors wieder verringert wird, wird die Haltespannung des Thyristors in einen Bereich verschoben, so dass die normale Betriebsspannung der mit der ESD-Schutz-Vorrichtung zu schützenden Schaltung unterhalb dieser Haltespannung liegt oder der Haltestrom auf ein Stromniveau gebracht wird, welches vom System nicht geliefert werden kann, so dass der Thyristor nach dem Ableiten einer Überspannung wieder in den hochohmigen Zustand zurückkehrt.

Dabei geschieht die Ansteuerung insbesondere mit Hilfe eines Schalters der ESD-Schutz-Vorrichtung, wodurch der Widerstand, welcher entweder zwischen einem ersten Anschluss des Thyristors, welcher mit der ersten Leitung verbindbar ist, und einem ersten Punkt innerhalb des Thyristors oder zwischen einem zweiten Anschluss des Thyristors, welcher mit der zweiten Leitung verbindbar ist, und einem zweiten Punkt innerhalb des Thyristors anliegt, einen geringen Widerstandswert aufweist, wenn der Schalter geschlossen ist, und einen hohen Widerstandswert aufweist, wenn der Schalter geöffnet ist. Gleichzeitig steuert das ESD-Signal die Basis eines der im Thyristor vorliegenden Transistoren derart an, dass die ESD-Schutz-Vorrichtung initiiert wird. Dabei ist es insbesondere vorteilhaft, dass nur durch das ESD-Signal sowohl der Widerstand als auch die Basis der Transistoren gesteuert werden. Dies ermöglicht eine kompakte Implementierung der ESD-Schutz-Vorrichtung und ein zuverlässiges Ansteuern der ESD-Schutz-Vorrichtung.

Die Ansteuerung wird dabei mittels des ESD-Signals von der ESD-Schutz-Vorrichtung initiiert.

Mit anderen Worten wird eine elektrische Verbindung zwischen einem bestimmten (ersten oder zweiten) Anschluss des Thyristors und einem bestimmten (ersten oder zweiten) Punkt innerhalb des Thyristors durch den geöffneten Schalter unterbrochen, wodurch der Widerstand zwischen dem bestimmten Anschluss und dem bestimmten Punkt einen höheren Wert aufweist, als wenn der Schalter geschlossen ist. Diese Veränderung des Widerstandswertes mit Hilfe des Schalters, welcher insbesondere ein Transistor ist, ist vorteilhafter Weise sehr robust und einfach zu realisieren.

Bei einer erfindungsgemäßen Ausführungsform umfasst der Thyristor einen ersten Transistor eines ersten Leistungstyps, insbesondere einen PNP-Transistor, und einen zweiten Transistor eines zweiten zum ersten Leitungstyp unterschiedlichen Leitungstyps, insbesondere einen NPN-Transistor. Dabei ist der erste Anschluss des Thyristors mit dem Emitter des ersten Transistors und über den Schalter der ESD-Schutz-Vorrichtung mit dem Steuereingang des ersten Transistors und dem Kollektor des zweiten Transistors verbunden. Zusätzlich ist der Kollektor des ersten Transistors mit dem Steuereingang des zweiten Transistors, dem zweiten Anschluss des Thyristors und dem Emitter des zweiten Transistors verbunden. Dabei wird der Schalter im ESD-Fall durch das ESD-Signal geöffnet und der Thyristor im ESD-Fall mittels des ESD-Signals zur Durchschaltung angesteuert, während der Schalter im Nicht-ESD-Fall, d. h. der ESD-Fall liegt nicht vor, durch das ESD-Signal geschlossen wird.

Erfindungsgemäß sind die beiden Transistoren des Thyristors vorzugsweise ein PNP-Transistor und ein NPN-Transistor. Allerdings kann es sich auch um andere Transistoren mit unterschiedlichem Leitungstyp, beispielsweise um einen PMOS-Transistor und einen NMOS-Transistor handeln.

Indem der Schalter, welcher insbesondere ein Transistor ist, im ESD-Fall geöffnet wird, wird der Widerstand zwischen dem ersten Anschluss des Thyristors und dem Steuereingang des ersten Transistors und der Widerstand zwischen dem ersten Anschluss des Thyristors und dem Kollektor des zweiten Transistors gegenüber einem Zustand, in welchem der Schalter geschlossen ist, vergrößert. Da ein Schalter, insbesondere ein Transistor, gerade bei Halbleiterschaltungen sehr einfach zu realisieren ist, ist die erfindungsgemäße ESD-Schutz-Vorrichtung vorteilhafter Weise mit einem nur geringen Flächen-Overhead im Vergleich zu einem normalen Thyristor (ohne Schalter) herzustellen, bietet aber trotzdem die bereits vorab beschriebenen Vorteile hinsichtlich verbesserter Durchschaltebedingungen und hinsichtlich der Vermeidung von Latching im Vergleich zu einem normalen Thyristor (ohne Schalter).

Bei der ersten Leitung und der zweiten Leitung liegt das Potenzial der ersten Leitung insbesondere über dem Potenzial der zweiten Leitung. Außerdem können die erste Leitung und die zweite Leitung Versorgungsspannungsleitungen sein. Allerdings sind auch andere Konstellationen möglich. Zum Beispiel kann es sich bei der ersten Leitung um einen Ein/Ausgangsanschluss einer vor ESD zu schützenden Schaltung handeln, d. h. die erfindungsgemäße ESD-Schutz-Vorrichtung hat die Aufgabe, eine Überspannung an diesem Ein/Ausgangsanschluss über die zweite Leitung abzuleiten, bevor die zu schützende Schaltung beschädigt wird.

Außerdem gibt es eine erfindungsgemäße Ausführungsform, bei welcher die ESD-Schutz-Vorrichtung eine Ansteuerungsvorrichtung umfasst, welche den ESD-Fall zwischen der ersten und der zweiten Leitung erfassen kann und somit in der Lage ist, das ESD-Signal zu erzeugen.

Vorteilhafter Weise muss folglich bei dieser Ausführungsform das ESD-Signal nicht der ESD-Schutz-Vorrichtung zugeführt werden.

Im Rahmen der vorliegenden Erfindung wird auch eine ESD-Schutz-Anordnung bereitgestellt, welche mindestens eine der vorab beschriebenen ESD-Schutz-Vorrichtungen umfasst. Die ESD-Schutz-Anordnung ist dabei zwischen genauso vielen ersten Leitungen, wie sie ESD-Schutz-Vorrichtungen umfasst, und der zweiten Leitung angeordnet, wobei zwischen jeder ersten Leitung und der zweiten Leitung jeweils eine ESD-Schutz-Vorrichtung angeordnet ist. Dabei ist der ESD-Schutz-Anordnung ein weiteres ESD-Signal zuführbar, welches von der ESD-Schutz-Anordnung an jede ihrer ESD-Schutz-Vorrichtungen als das ESD-Signal der jeweiligen ESD-Schutz-Vorrichtung weitergeleitet wird. Das weitere ESD-Signal kann dabei zwei unterschiedliche Werte bzw. Potenziale aufweisen. Für den Fall, dass der ESD-Fall zwischen irgendeiner ersten Leitung und der zweiten Leitung auftritt weist das weitere ESD-Signal ein anderes Potenzial auf, als wenn kein ESD-Fall zwischen den ersten Leitungen, an denen die ESD-Schutz-Anordnung angeordnet ist, und der zweiten Leitung vorliegt. Der ESD-Fall kann dabei sowohl anhand der Überschreitung einer oberen Spannungsschwelle (z.B. Durchbruch einer geeigneten Zenerdiode) als auch durch Auftreten kritischer Spannungsrampen (RC-Glieder) detektiert werden.

Damit ist die ESD-Schutz-Anordnung in der Lage, eine Überspannung, welche an irgendeiner der der ESD-Schutz-Anordnung zugeordneten ersten Leitungen auftritt, über die entsprechende mit dieser ersten Leitung verbundene ESD-Schutz-Vorrichtung abzuleiten.

Da die erfindungsgemäße ESD-Schutz-Anordnung auch nur eine ESD-Schutz-Vorrichtung umfassen kann, entspricht die ESD-Schutz-Anordnung in diesem Fall dieser einen ESD-Schutz-Vorrichtung, wobei auch das weitere ESD-Signal in diesem Fall (die ESD-Schutz-Anordnung umfasst nur eine ESD-Schutz-Vorrichtung) dem ESD-Signal entspricht.

Die erfindungsgemäße ESD-Schutz-Anordnung eignet sich vorzugsweise zum Schutz von Schaltungen, welche mit mehreren unterschiedlichen Versorgungsspannungspotenzialen, beispielsweise mit einem Versorgungsspannungspotenzial zwischen 3 bis 5V, einem Versorgungsspannungspotenzial zwischen 1 bis 1,5V und einem auf Masse liegenden Versorgungsspannungspotenzial, arbeiten.

Bei einer erfindungsgemäßen Ausführungsform der ESD-Schutz-Anordnung, umfasst die ESD-Schutz-Anordnung eine Ansteuerungsvorrichtung, welche den ESD-Fall zwischen irgendeiner der der ESD-Schutz-Anordnung zugeordneten ersten Leitung und der zweiten Leitung erfasst und das weitere ESD-Signal entsprechend erzeugt.

Damit ist die erfindungsgemäße ESD-Schutz-Anordnung vorteilhafter Weise nicht mehr auf eine Zulieferung des weiteren ESD-Signals angewiesen.

Im Rahmen der vorliegenden Erfindung wird auch ein ESD-Schutz-System bereitgestellt, welches mindestens eine vorab beschriebene erfindungsgemäße ESD-Schutz-Anordnung umfasst. Dabei ist das ESD-Schutz-System zwischen mindestens einer ersten Leitung und der zweiten Leitung derart angeordnet, dass zwischen jeder ersten Leitung und der zweiten Leitung mindestens eine der ESD-Schutz-Anordnungen des ESD-Schutz-Systems angeordnet ist. Zusätzlich ist jede ESD-Schutz-Anordnung mit einem Bus des ESD-Schutz-Systems verbunden, über welchen jeder ESD-Schutz-Anordnung das weitere ESD-Signal zugeführt wird.

Bei einer bevorzugten Ausführungsform umfasst das ESD-Schutz-System mindestens eine Ansteuerungsvorrichtung, welche ähnlich wie bei der ESD-Schutz-Anordnung mit allen ersten Leitungen und der zweiten Leitung kontaktierbar ist und das weitere ESD-Signal erzeugt und dem Bus zuführt.

Damit ist das erfindungsgemäße ESD-Schutz-System in der Lage, den ESD-Fall, welcher zwischen irgendeiner der ersten Leitungen und der zweiten Leitung auftritt, zu erfassen und über mindestens eine ESD-Schutz-Anordnung, welche, wie oben ausgeführt ist, auch eine ESD-Schutz-Vorrichtung sein kann, abzuführen. Zum Schutz einer Schaltung gegenüber. Überspannungen kann das ESD-Schutz-Systemen dabei derart ausgestaltet sein, dass die ESD-Schutz-Anordnungen bzw. ESD-Schutz-Vorrichtungen und eventuell die Ansteuerungsvorrichtungen irgendwo innerhalb der zu schützenden Schaltung angeordnet sind, wodurch das ESD-Schutz-System vorteilhafter Weise sehr flexibel aufgebaut werden kann.

Die vorliegende Erfindung eignet sich vorzugsweise zum Einsatz in mikroelektronischen Schaltungen, um diese mikroelektronischen Schaltungen vor elektrostatischen Entladungen zu schützen. Selbstverständlich ist die Erfindung jedoch nicht auf diesen bevorzugten Anwendungsbereich beschränkt, sondern kann auch bei mit diskreten Bauteilen aufgebauten Schaltungen eingesetzt werden.

Die vorliegende Erfindung wird nachfolgend näher unter Bezugnahme auf die beigefügte Zeichnung anhand bevorzugter Ausführungsbeispiele erläutert.

Fig. 1a zeigt eine Thyristor-Schaltung nach dem Stand der Technik, wobei in Fig. 1b eine zugehörige Strom-Spannungs-Kennlinie dargestellt ist.

In Fig. 2 sind nach dem Stand der Technik bekannte Verbesserungsmöglichkeiten von Thyristor-Schaltungen dargestellt.

In Fig. 3 ist eine Strom-Spannungs-Kennlinie einer gemäß Fig. 2 verbesserten Thyristor-Schaltung zusammen mit der üblichen Strom-Spannungs-Kennlinie dargestellt.

In Fig. 4 sind zwei Ausführungsformen von erfindungsgemäßen ESD-Schutz-Vorrichtungen dargestellt.

In Fig. 5 sind zwei Ausführungsformen von erfindungsgemäßen ESD-Schutz-Vorrichtungen dargestellt, wobei ein Teil dieser ESD-Schutz-Vorrichtungen als Halbleiter-Strukturen dargestellt sind.

Figuren 6a-d stellen vier Ausführungsformen von erfindungsgemäßen ESD-Schutz-Vorrichtungen dar, wobei noch ein größerer Anteil dieser ESD-Schutz-Vorrichtungen als Halbleiter-Strukturen dargestellt ist.

Fig. 6e stellt die Ausführungsformen der Fig. 6a dar, wobei zusätzlich die von den Halbleiter-Strukturen ausgebildeten Bauelemente schematisch dargestellt sind.

Fig. 7 stellt eine erfindungsgemäße ESD-Schutz-Anordnung, welche zwei Thyristor-Schaltungen bzw. ESD-Schutz-Vorrichtungen umfasst, dar.

Fig. 8 stellt die in Fig. 7 dargestellte ESD-Schutz-Anordnung mit Halbleiter-Strukturen, welche in einer erfindungsgemäßen Art und Weise angeordnet sind, dar.

Fig. 9 stellt ein erfindungsgemäßes ESD-Schutz-System dar.

Fig. 10 stellt ein erfindungsgemäßes ESD-Schutz-System mit zwei Ein/Ausgabe-Anordnungen dar.

Fig. 11 stellt eine erfindungsgemäße ESD-Schutz-Vorrichtung mit einer Wannensteuerschaltung dar.

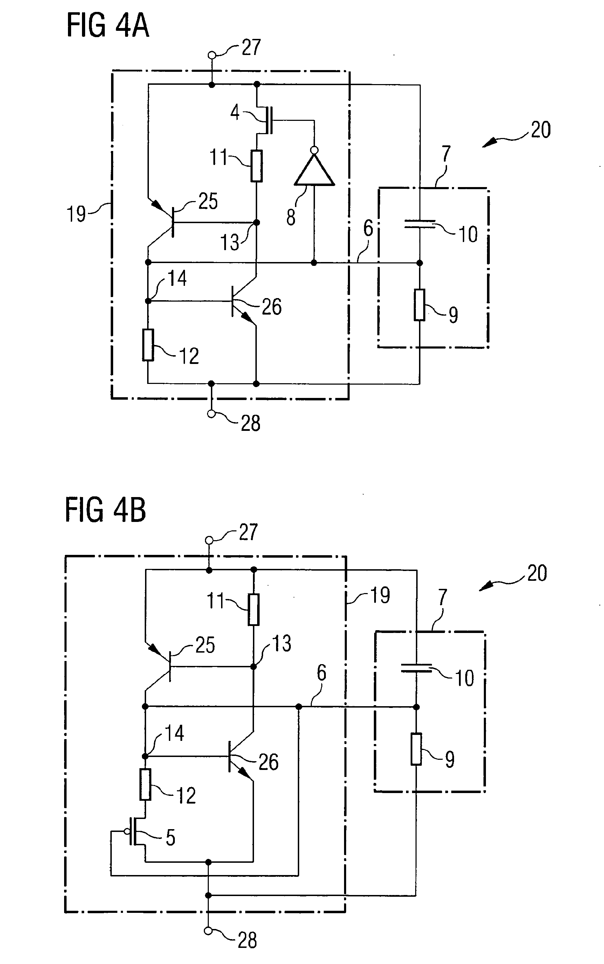

Fig. 4a stellt eine erfindungsgemäße ESD-Schutz-Vorrichtung 19 dar, welche eine elektrostatische Entladung, die zwischen einem ersten Anschluss 27 und einem zweiten Anschluss 28 der ESD-Schutz-Vorrichtung 19 anliegt, ableitet, wobei das Potenzial des ersten Anschlusses 27 höher als das Potenzial des zweiten Anschlusses 28 ist (beispielsweise kann der erste Anschluss 27 mit V_{DD} und der zweite Anschluss 28 mit V_{SS} verbunden sein) . Dabei ist der erste Anschluss 27 mit dem Emitter eines PNP-Transistors 25 und über einen NMOS-Transistor 4 und einen n-Wannen-Widerstand 11 mit der Basis des PNP-Transistors 25 und dem Kollektor eines NPN-Transistors 26 verbunden. Der Kollektor des PNP-Transistors 25 ist mit der Basis des NPN-Transistors 26, mit einem ESD-Signal 6 und über einen p-Wannen-Widerstand 12 mit dem zweiten Anschluss 28 verbunden. Der Emitter des NPN-Transistors 26 ist ebenfalls mit dem zweiten Anschluss 28 verbunden. Das über einen Inverter 8 invertierte ESD-Signal 6 steuert den NMOS-Transistor 4. Ein Kontaktpunkt 13 vor der Basis des PNP-Transistors 25 wird dabei als n-Wannen-Kontakt und ein Kontaktpunkt 14 vor der Basis des NPN-Transistors 26 wird dabei als p-Wannen-Kontakt bezeichnet. Das ESD-Signal 6 wird von einer Ansteuerungsvorrichtung 7 geliefert. Diese Ansteuerungsvorrichtung 7 umfasst einen Kondensator 10 und einen Widerstand 9, welche in Reihe zwischen den ersten Anschluss 27 und den zweiten Anschluss 28 geschaltet sind. Dabei wird das ESD-Signal 6 zwischen dem Kondensator 10 und dem Widerstand 9 abgegriffen. Mit einem Bezugszeichen 20 wird eine ESD-Schutz-Vorrichtung bezeichnet, welche die Ansteuerungsvorrichtung 7 umfasst. Mit anderen Worten ist der Unterschied zwischen der ESD-Schutz-Vorrichtung 19 und der ESD-Schutz-Vorrichtung 20 derjenige, dass die ESD-Schutz-Vorrichtung 20 die Ansteuerungsvorrichtung 7 umfasst, während die ESD-Schutz-Vorrichtung 19 keine Ansteuerungsvorrichtung 7 umfasst. Das heißt, während die ESD-Schutz-Vorrichtung 20 das ESD-Signal 6 selbst erzeugt, wird das ESD-Signal 6 der ESD-Schutz-Vorrichtung 19 zugeliefert.

Wenn eine elektrostatische Entladung bzw. ein ESD-Fall von der Ansteuerungsvorrichtung 7 erfasst wird, setzt die Ansteuerungsvorrichtung 7 das ESD-Signal 6 auf ein hohes Potenzial (Binärwert 1), welches etwas unterhalb eines am ersten Anschluss anliegenden Potenzials (V_{DD}) liegt. Dadurch wird die Basis des NPN-Transistors 26 aufgesteuert und der NMOS-Transistor 4 abgeschaltet, so dass eine Verbindung zwischen dem ersten Anschluss 27 und dem n-Wannen-Kontakt 13 hochohmig ist. Dies ermöglicht der ESD-Schutz-Vorrichtung 19 bzw. 20 auch bei einem geringen Stromniveau schnell zu schalten (in den Durchlassbereich des Thyristors zu kommen), da nahezu der gesamte Strom von dem ersten Anschluss 27 über die Emitter-Basis-Verbindung des PNP-Transistors 25 strömt, da die Verbindung von dem ersten Anschluss 27 zu der Basis des PNP-Transistors 25 unterbrochen bzw. hochohmig ist. Dadurch ist eine gute ESD-Schutz-Eigenschaft durch die ESD-Schutz-Vorrichtung 19 bzw. 20 gewährleistet.

Wenn die Ansteuerungsvorrichtung 7 keinen ESD-Fall erfasst, was der normale Betriebszustand ist, besitzt das ESD-Signal 6 ein niedriges Potenzial (Binärwert 0), welches in der Nähe eines an dem zweiten Anschluss 28 anliegenden Potenzials (V_{SS}) liegt. Das heißt, im normalen Betriebszustand ist die Verbindung von dem ersten Anschluss 27 zu dem n-Wannen-Kontakt 13 niederohmig, da der NMOS-Transistor 4 geschlossen ist. Dadurch ist sichergestellt, dass kein Latching auftritt.

Der Unterschied zwischen der Fig. 4a und der Fig. 4b ist, dass anstelle des NMOS-Transistors 4 zwischen dem ersten Anschluss 27 und dem n-Wannen-Widerstand 11 ein PMOS-Transistor 5 zwischen dem zweiten Anschluss 25 und dem p-Wannen-Widerstand 12 geschaltet ist. Beim ESD-Fall (das ESD-Signal 6 besitzt den Binärwert 1) ist der PMOS-Transistor 5 geöffnet, wodurch die Verbindung zwischen dem zweiten Anschluss und dem p-Wannen-Kontakt 14 hochohmig ist. Dies ermöglicht der ESD-Schutz-Vorrichtung 19 bzw. 20 wiederum, bei einem geringen Stromniveau schnell zu schalten, da nahezu der gesamte Strom, welcher zu dem zweiten Anschluss 28 strömt, über die Basis-Emitter-Verbindung des NPN-Transistors 26 strömt, da die Verbindung von der Basis des NPN-Transistors 26 zu dem zweiten Anschluss 28 unterbrochen bzw. hochohmig ist. Dadurch ist wie bei Fig. 4a eine gute ESD-Schutz-Eigenschaft durch die ESD-Schutz-Vorrichtung 19 bzw. 20 der Fig. 4b gewährleistet.

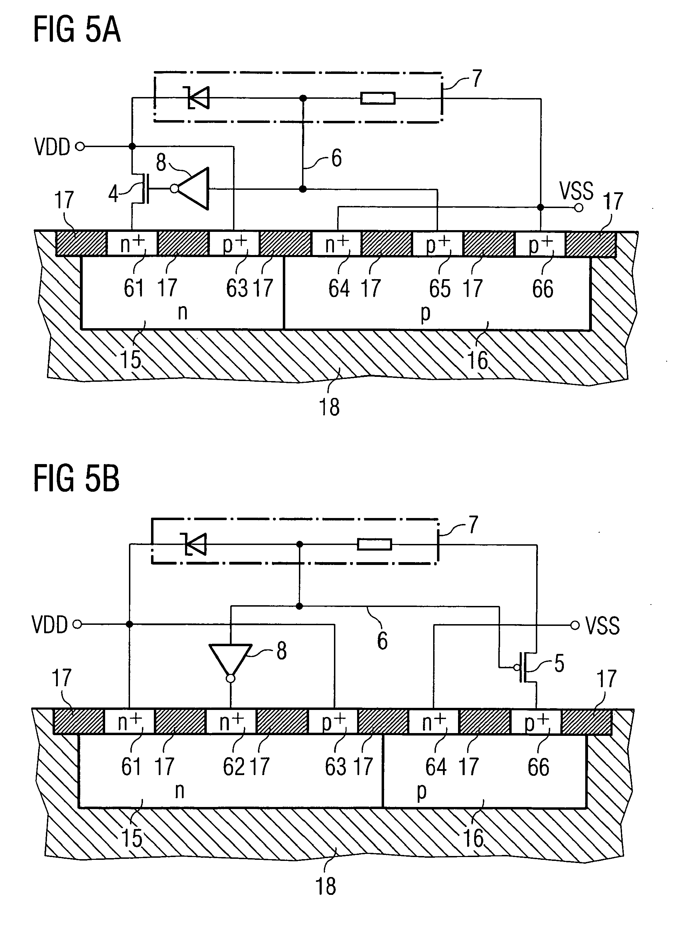

In Fig. 5a ist die ESD-Schutz-Vorrichtung 19 bzw. 20 der Fig. 4a dargestellt, wobei ein gewisser Anteil der ESD-Schutz-Vorrichtung mittels Halbleiterstrukturen dargestellt ist. In einem p-Substrat 18 sind eine n-Wanne 15 und eine p-Wanne 16 direkt miteinander benachbart ausgebildet, wobei die p-Wanne 16 rechts neben der n-Wanne 15 angeordnet ist. Der erste Anschluss bzw. V_{DD} ist über den NMOS-Transistor 4 mit einem n+-Gebiet 61, welches links innerhalb der n-Wanne 15 angeordnet ist, verbunden. Zusätzlich ist der erste Anschluss bzw. V_{DD} mit einem p+-Gebiet 63 (Emitter des PNP-Transistors), welches durch eine Isolationsschicht 17 getrennt rechts neben dem n+-Gebiet 61 angeordnet ist, verbunden. Der zweite Anschluss bzw. V_{SS} ist mit einem n+-Gebiet 64 (Emitter des NPN-Transistors), welches links in der p-Wanne 16 angeordnet ist, verbunden, wobei das p+-Gebiet 63 durch eine Isolationsschicht 17 von dem n+-Gebiet 64 getrennt ist. Das ESD-Signal 6 ist mit einem p+-Gebiet 65, welches durch eine Isolationsschicht 17 getrennt rechts neben dem n+-Gebiet 64 in der p-Wanne 16 angeordnet ist, verbunden. Der zweite Anschluss bzw. V_{SS} ist mit einem p+-Gebiet 66, welches durch eine Isolationsschicht 17 getrennt rechts neben dem p+-Gebiet 65 in der p-Wanne 16 liegt, verbunden. Damit bildet sich über das p+-Gebiet 63, die n-Wanne 15 und die p-Wanne 16 der PNP-Transistor und über das n+-Gebiet 64, die p-Wanne 16 und die n-Wanne 15 der NPN-Transistor aus.

Da der NMOS-Transistor 4 über das n+-Gebiet 61 mit der n-Wanne 15 verbunden ist, wird bei der in Fig. 5a dargestellten Ausführungsform der Widerstand der Verbindung zu der n-Wanne über den NMOS-Transistor 4 gesteuert bzw. geschaltet. Eine dieser Ausführungsform entsprechende Halbleiterschaltung kann z. B. mit einem standardisierten (Zwillings-Wannen-Produktionsverfahren) ("Twinwell Process") mit einem Wafer von einem P-Typ hergestellt werden.

Die in Fig. 5b dargestellte ESD-Schutz-Vorrichtung ist mit der in Fig. 5a dargestellten vergleichbar, weshalb im Folgenden nur die Unterschiede ausgeführt werden. Anstatt das ESD-Signal 6 über das p+-Gebiet 65 zuzuführen, wird ein invertiertes ESD-Signal 6 einem weiteren in der n-Wanne 15 zwischen dem n+-Gebiet 61 und dem p+-Gebiet 63 angeordneten mit Isolationsschichten 17 isolierten n+-Gebiet 62 zugeführt, um die ESD-Schutz-Vorrichtung im ESD-Fall zum Durchschlag anzuregen. Aus diesem Grund entfällt bei der ESD-Schutz-Vorrichtung der Fig. 5b das p+-Gebiet 65. Während in Fig. 5b im Gegensatz zu Fig. 5a der erste Anschluss bzw. V_{DD} direkt mit dem n+-Gebiet 61 verbunden ist, ist der zweite Anschluss bzw. V_{SS} über den PMOS-Transistor 5 mit dem p+-Gebiet 66 verbunden. Bei der in Fig. 5b dargestellten Ausführungsform wird also der Widerstand der Verbindung zu der p-Wanne über den PMOS-Transistor 5, welcher durch das nicht invertierte ESD-Signal gesteuert wird, gesteuert bzw. geschaltet.

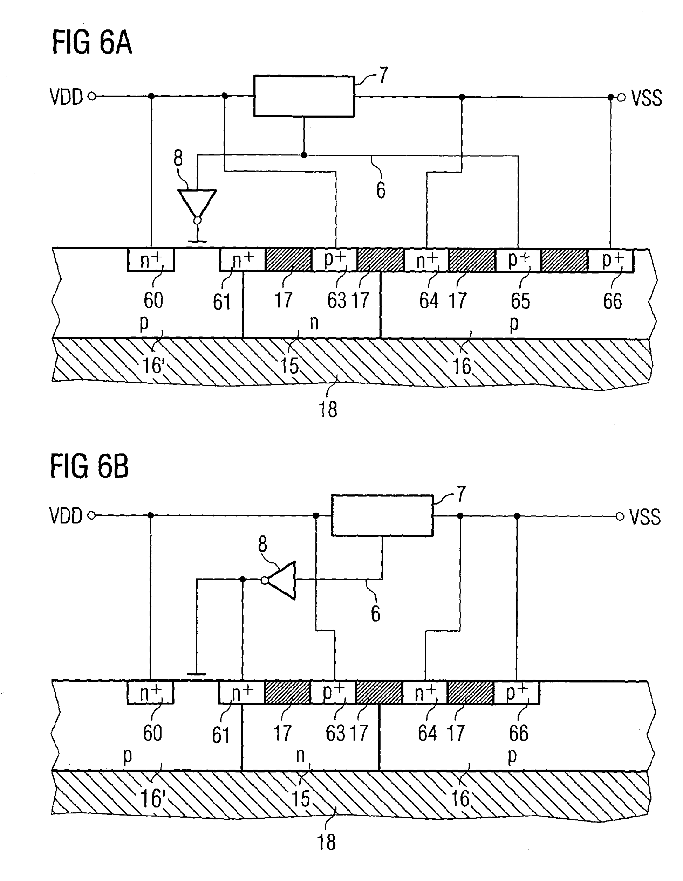

In Fig. 6a ist die in Fig. 4a und Fig. 5a dargestellte ESD-Schutz-Vorrichtung 19 bzw. 20 dargestellt, wobei ein noch größerer Anteil der ESD-Schutz-Vorrichtung mittels Halbleiterstrukturen dargestellt ist. Deshalb wird bei der Beschreibung der Fig. 6a nur auf die Unterschiede bzw. Ergänzungen im Bezug auf Fig. 5a eingegangen.

Bei der in Fig. 6a dargestellten ESD-Schutz-Vorrichtung befindet sich links neben der n-Wanne 15 eine weitere p-Wanne 16'. In dieser p-Wanne 16' ist links ein n+-Gebiet 60 angeordnet, welches mit dem ersten Anschluss bzw. V_{DD} verbunden ist. Das n+-Gebiet 61 ist bei der Ausführungsform der Fig. 6a im Gegensatz zu der Ausführungsform der Fig. 5a nicht vollständig innerhalb der n-Wanne 15 angeordnet, sondern befindet auf der Grenze zwischen der p-Wanne 16' und der n-Wanne 15 und ist derart angeordnet, dass sich das n+-Gebiet 61 zu einem Teil in der p-Wanne 16' und zum restlichen Teil in der n-Wanne 15 befindet. Damit ist die in Fig. 6a dargestellte ESD-Schutz-Vorrichtung in einer vorteilhaften kompakten Bauweise ausgebildet. An ein zwischen dem n+-Gebiet 60 und dem n+-Gebiet 61 liegendes Gebiet wird das invertierte ESD-Signal 6 angeschaltet.

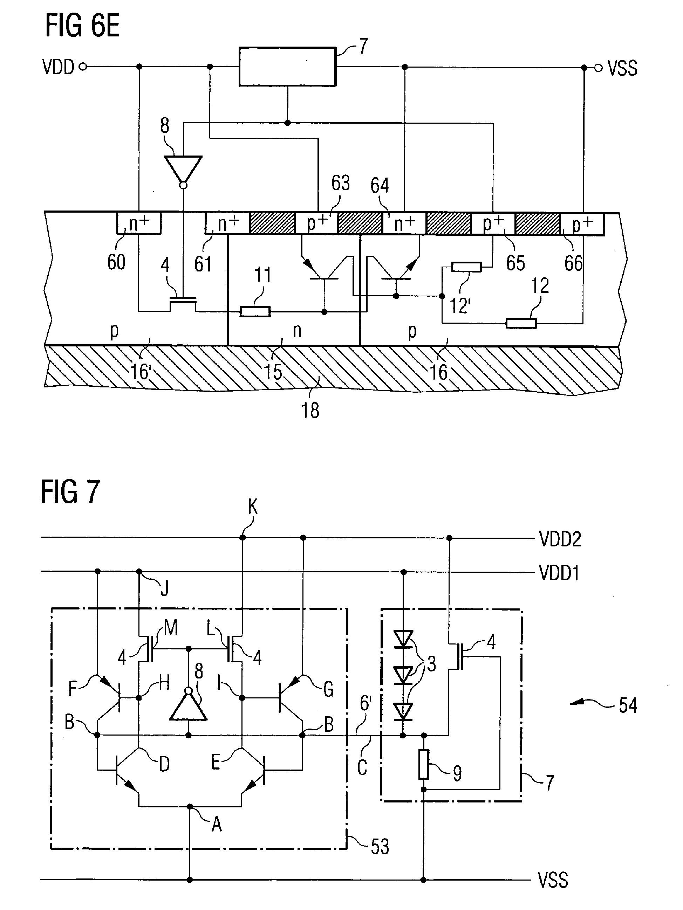

In Fig. 6e ist die in Fig. 6a dargestellte ESD-Schutz-Vorrichtung nochmals dargestellt, wobei zusätzlich schematisch dargestellt ist, welche Bauteile durch die Halbleiterschichten ausgebildet sind. Man erkennt, dass zwischen dem n+-Gebiet 60 und dem n+-Gebiet 61 der NMOS-Transistor 4 und dass zwischen dem NMOS-Transistor 4 und der Basis des PNP-Transistors der n-Wannen-Widerstand 11 ausgebildet ist. Zwischen dem p+-Gebiet 66 bzw. dem p+-Gebiet 65 und der Basis des NPN-Transistors ist der p-Wannen-Widerstand 12 bzw. ein weiterer p-Wannen-Widerstand 12' ausgebildet. Fig. 6e zeigt die vorteilhafte kompakte Struktur der ESD-Schutz-Vorrichtung, beispielsweise bildet die n-Wanne 15 zum einen die Basis des PNP-Transistors und zum anderen den Kollektor des NPN-Transistors aus, während andererseits die p-Wanne 16 zum einen die Basis des NPN-Transistors und zum anderen den Kollektor des PNP-Transistors ausgebildet.

Die in Fig. 6b dargestellte Ausführungsform einer ESD-Schutz-Vorrichtung ist mit der in Fig. 6a dargestellten Ausführungsform sehr verwandt, weshalb im Folgenden nur die Unterschiede diskutiert werden. Während die in Fig. 6a dargestellte ESD-Schutz-Vorrichtung im ESD-Fall zum Durchschlag angereizt wird, indem das ESD-Signal 6 dem p+-Gebiet 65 zugeführt wird, wird das durch den Inverter 8 invertierte ESD-Signal 6 in Fig. 6b dem n+-Gebiet 61 zugeführt, um im ESD-Fall den Durchschlag der Thyristor-Schaltung herbeizuführen. Deshalb kann bei der in Fig. 6b dargestellten Ausführungsform das p+-Gebiet 65 eingespart werden, was zu einer noch kompakteren Struktur führt.

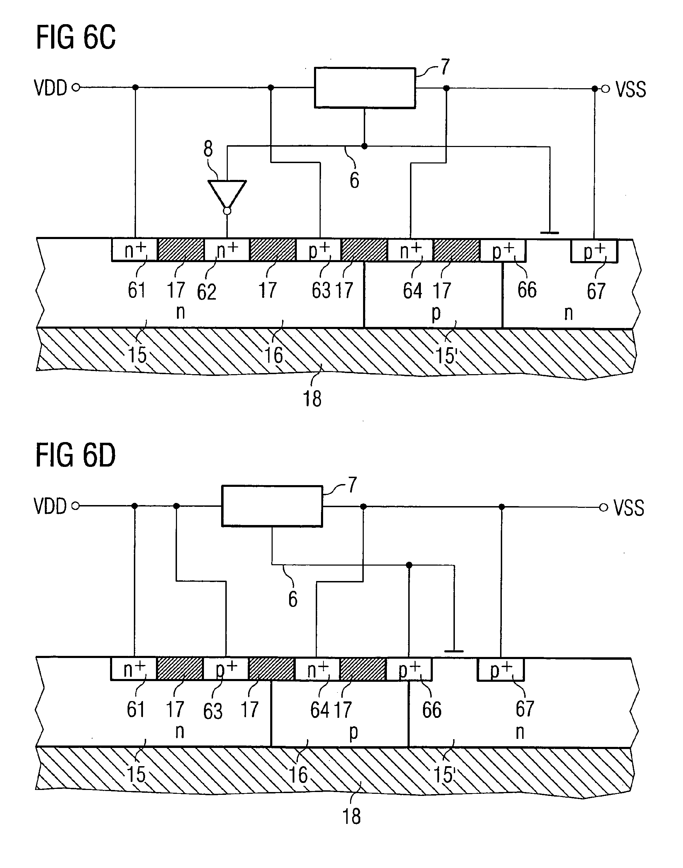

In Fig. 6c ist die in Fig. 5b dargestellte ESD-Schutz-Vorrichtung dargestellt, wobei weitere Halbleiterstrukturen aufgezeigt sind. Deshalb werden nur die Ergänzungen zu Fig. 5b erläutert. Während das p+-Gebiet 66 in Fig. 5b innerhalb der p-Wanne 16 angeordnet ist, liegt das p+-Gebiet 66 in Fig. 6c sowohl innerhalb der p-Wanne 16 als auch innerhalb einer weiteren n-Wanne 15', welche rechts neben der p-Wanne 16 angeordnet ist. Beabstandet von dem p+-Gebiet 66 ist ein p+-Gebiet 67 angeordnet, welches mit dem zweiten Anschluss bzw. V_{SS} verbunden ist. Das ESD-Signal 6 ist mit einem Gebiet zwischen dem p+-Gebiet 66 und dem p+-Gebiet 67 verbunden, wodurch sich von dem p+-Gebiet 67 bis zu dem p+-Gebiet 66 der PMOS-Transistor 5 ausbildet. Damit schaltet der PMOS-Transistor 5 bei der in Fig. 6c dargestellten Ausführungsform einen Widerstand zwischen der p-Wanne 16 und dem zweiten Anschluss bzw. V_{SS}. Zur Anregung eines Durchschlags der Thyristor-Schaltung im ESD-Fall wird in Fig. 6c das invertierte ESD-Signal 6 dem n+-Gebiet 62 zugeführt.

In Fig. 6d ist eine der in Fig. 6c dargestellten Ausführungsform verwandte Ausführungsform der ESD-Schutz-Vorrichtung dargestellt, weshalb im Folgenden nur die Unterschiede herausgearbeitet werden. Während das invertierte ESD-Signal 6 in Fig. 6c dem n+-Gebiet 62 zugeführt wird, wird in Fig. 6d das ESD-Signal 6 dem p+-Gebiet 66 zur Anregung eines Durchbruchs im ESD-Fall zugeführt. Da die in Fig. 6d dargestellte Ausführungsform keinen Inverter 8 für das ESD-Signal 6 benötigt, ist die in Fig. 6d dargestellte Ausführungsform noch kompakter als die in Fig. 6b dargestellte Ausführungsform der ESD-Schutz-Vorrichtung.

Fig. 7 stellt eine ESD-Schutz-Anordnung 53 bzw. 54 dar, welche zwei Thyristor-Schaltungen umfasst. Dabei umfasst die ESD-Schutz-Anordnung 54 eine Ansteuerungsvorrichtung 7, welche ein weiteres ESD-Signal 6' erzeugt, während die ESD-Schutz-Anordnung 53 keine eigene Ansteuerungsvorrichtung 7 aufweist, weshalb der ESD-Schutz-Anordnung 53 das weitere ESD-Signal 6' von außen zugeführt werden muss. Die Ansteuerungsvorrichtung 7 erfasst sowohl den ESD-Fall zwischen V_{DD1} und V_{SS} als auch den ESD-Fall zwischen V_{DD2} und V_{SS}, wobei in beiden Fällen das weitere ESD-Signal 6' von der Ansteuerungsvorrichtung 7 auf ein hohes Potenzial (Binärwert 1) gelegt wird, während das weitere ESD-Signal 6' von der Ansteuerungsvorrichtung 7 auf ein niedriges Potenzial (Binärwert 0), welches nahezu V_{SS} entspricht, gelegt wird, wenn weder der ESD-Fall zwischen V_{DD1} und V_{SS} noch der ESD-Fall zwischen V_{DD2} und V_{SS} um vorliegt. Dabei kann beispielsweise V_{DD1} einer niedrigen Versorgungsspannung im Bereich zwischen 1 bis 1,5V und V_{DD2} einer höheren Versorgungsspannung im Bereich von 3 bis 5V entsprechen.

Die ESD-Schutz-Anordnung 53 umfasst prinzipiell zwei ESD-Schutz-Vorrichtungen 19, wie sie in Fig. 4a ausgeführt sind. Nur der Inverter 8 ist bei der ESD-Schutz-Anordnung 53 nur einmal vorhanden und existiert nicht für jede der beiden ESD-Schutz-Vorrichtungen 19 einmal. Zur Übersichtlichkeit wurden die in Fig. 4a dargestellten Wannen-Widerstände 11, 12 in Fig. 7 nicht dargestellt. Während die in Fig. 7 links angeordnete ESD-Schutz-Vorrichtung zwischen V_{DD1} und V_{SS} liegt, liegt die in Fig. 7 rechts angeordnete ESD-Schutz-Vorrichtung zwischen V_{DD2} und V_{SS}. Da das weitere ESD-Signal 6' beiden ESD-Schutz-Vorrichtungen der ESD-Schutz-Anordnung 53 zugeführt wird, werden beide ESD-Schutz-Vorrichtungen zum Durchschlag angeregt, auch wenn der ESD-Fall nur zwischen V_{DD1} und V_{SS} oder nur zwischen V_{DD2} und V_{SS} vorliegt. Diese Besonderheit soll im Folgenden anhand eines beispielhaften Szenarios genauer erläutert werden.

Angenommen eine Überspannung liegt auf der V_{DD2} tragenden Leitung an, während auf der V_{DD1} tragenden Leitung keine Überspannung vorhanden ist. In diesem Fall erfasst die Ansteuerungsvorrichtung 7 in dem Zweig, welcher durch den NMOS-Transistor 4 und den Widerstand 9 ausgebildet ist, den ESD-Fall zwischen V_{DD2} und V_{SS}, wodurch das weitere ESD-Signal 6 auf den Binärwert 1 (höheres Potenzial) gesetzt wird. Da beide ESD-Schutz-Vorrichtungen der ESD-Schutz-Anordnung 53 in gleicher Weise mit dem weiteren ESD-Signal 6' verbunden sind, werden beide ESD-Schutz-Vorrichtungen zum Durchschalten angeregt bzw. in einen niederohmigen Zustand versetzt, wodurch die Überspannung abgeleitet wird. Das heißt, obwohl zwischen V_{DD1} und Vₛₛ kein unmittelbarer ESD-Fall vorliegt, wird trotzdem die zwischen V_{DD1} und Vₛₛ angeordnete ESD-Schutz-Vorrichtung niederohmig geschaltet. Dies ist ein Vorteil, um komplexe Schaltungen zu schützen, an welche sowohl V_{DD1} als auch V_{DD2} als auch V_{SS} herangeführt werden. Beim ESD-Fall kommt es bei dieser Art von Schaltung in aller Regel sowohl zu einer Überspannung zwischen V_{SS2} und V_{DD} als auch zwischen V_{SS1} und V_{DD}. Deshalb ist es vorteilhaft, auch die zwischen V_{DD1} und V_{SS} angeordnete ESD-Schutz-Vorrichtung niederohmig zu schalten, auch wenn in diesem Moment (noch) kein ESD-Fall zwischen V_{DD1} und V_{SS} detektiert wurde.

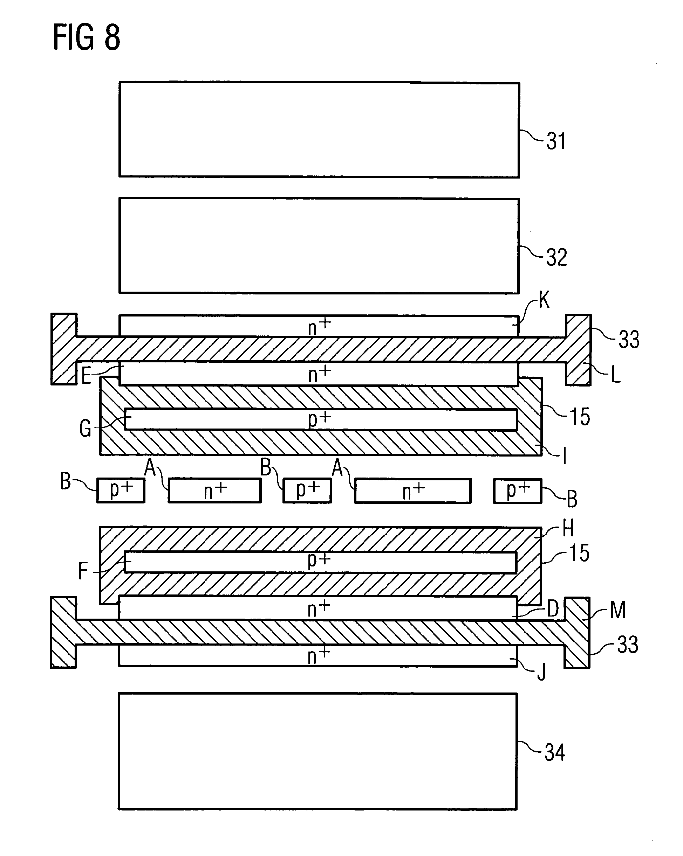

Fig. 8 stellt dar, wie die in Fig. 7 dargestellte ESD-Schutz-Anordnung 53 als Halbleiterstruktur in vorteilhafter Weise kompakt angeordnet werden kann, wobei allerdings der Inverter 8 aus darstellerischen Gründen ausgespart ist. Um die Beziehung zwischen der Fig. 7 und der Fig. 8 zu erleichtern, wurden an in Beziehung stehenden Stellen Bezugszeichen A-M sowohl in Fig. 7 als auch in Fig. 8 eingeführt. Die in Fig. 8 dargestellte Ausführungsform einer ESD-Schutz-Anordnung ist durch ein besonders Flächen effizientes Layout ausgezeichnet und dient beispielsweise als eine Power-Clamp. Die hier dargestellte Ausführungsform ist in einer typischen Ein/Ausgabe-Zelle angeordnet.

In Fig. 8 sind zwei n-Wannen 15 getrennt durch eine Anordnung, welche aus drei p+-Gebieten B und zwei n+-Gebieten A besteht, übereinander angeordnet, wobei die untere n-Wanne 15 einen n-Wannen-Kontakt H und die obere n-Wanne 15 einen n-Wannen-Kontakt I aufweist. Die drei p+-Gebiete und die zwei n+-Gebiete sind nebeneinander in einer Ausrichtung von links nach rechts angeordnet. Dabei ist sowohl innerhalb der oberen n-Wanne 15 ein p+-Gebiet G als auch innerhalb der unteren n-Wanne 15 ein p+-Gebiet F vorhanden. Oberhalb des p+-Gebietes G bzw. unterhalb des p+-Gebietes F ist ein n +-Gebiet Ebzw. D vorhanden, welches teilweise innerhalb der n-Wanne 15 und teilweise außerhalb der n-Wanne 15 angeordnet ist. An das oben liegende n+-Gebiet E schließt sich eine Polysiliziumschicht 33 bzw. L gefolgt von einem weiteren n+-Gebiet K an, in ähnlicher Weise schließt sich an das unten liegende n+-Gebiet D eine Polysiliziumschicht 33 bzw. M gefolgt von einem weiteren n+-Gebiet J an.

Es sei angemerkt, dass sich die n-Wannen 15 auch bis zu einer Grenze der Ein/Ausgabe-Zelle erstrecken können, um einen kontinuierlichen n-Wannen-Schutzring um die Ein/Ausgabe-Zelle zu bilden. Auch kann bei der Anordnung zwischen den beiden n-Wannen anstelle der sich periodisch abwechselnden p+-Gebiete B und n+-Gebiete A eine sich wiederholende Folge von Unteranordnungen angeordnet werden, wobei jede Unteranordnung aus zwei n+-Gebieten besteht, welche durch ein p+-Gebiet getrennt sind.

Die Polysiliziumschichten 33 bilden die Steuereingänge L bzw. M der den Widerstand zu der jeweiligen n-Wanne 15 schaltenden NMOS-Transistoren, dass heißt, sie sind mit dem invertierten weiteren ESD-Signal 6' (nicht dargestellt) verbunden. Zur Anregung eines Durchbruchs im ESD-Fall wird das weitere ESD-Signal 6' bei B eingespeist. Die Versorgungsspannung V_{DD1} (1 bis 1,5V) wird bei J und F zugeführt, während die Versorgungsspannung V_{DD2} (3 bis 5V) bei K und G zugeführt wird. Die Versorgungsspannung V_{SS} (Masse) wird mit A verbunden.

Oberhalb der ESD-Schutz-Anordnung sind in Fig. 8 der NFET-Treiber 31 und der PFET-Treiber 32, welche beide mit V_{DD2} arbeiten, angeordnet, während unterhalb der ESD-Schutz-Anordnung ein Logikanteil, welcher mit V_{DD1} versorgt wird, angeordnet ist.

Die in Fig. 8 dargestellte ESD-Schutz-Anordnung bietet folgende Vorteile:
- Beide Thyristor-Schaltungen bzw. ESD-Schutz-Vorrichtungen teilen sich die zwischen den n-Wannen 15 angeordnete Anordnung von p+-Gebieten B und n+-Gebieten A.
- Die n+-Gebiete D bzw. E dienen zum einen zur Kontaktherstellung zu der entsprechenden n-Wanne für den entsprechenden Thyristor als auch als Source-Gebiet des entsprechenden NMOS-Transistors.
- Die n-Wannen 15 sichern die Versorgungsspannungen V_{DD1} bei F und V_{DD2} bei G gegenüber V_{SS} (Masse) und gegenüber der jeweils anderen Versorgungsspannung ab.

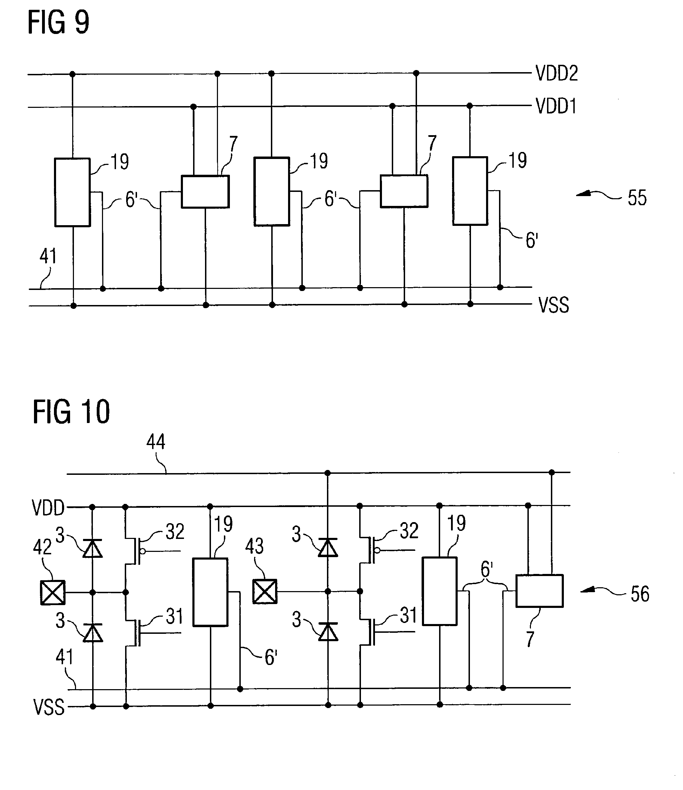

In Fig. 9 ist ein ESD-Schutz-System 55 dargestellt, welches eine nicht dargestellte Halbleiterschaltung vor einer elektrostatischen Entladung schützt. Dabei wird die geschützte Halbleiterschaltung von den Versorgungsspannungspotenzialen V_{DD1}, V_{DD2} und V_{SS} versorgt. Das ESD-Schutz-System 55 weist zwei Ansteuerungsvorrichtungen 7, drei ESD-Schutz-Anordnungen bzw. ESD-Schutz-Vorrichtungen 19 und einen ESD-Signalbus 41 auf. Jede Ansteuerungsvorrichtung 7 führt das weitere ESD-Signal 6' dem ESD-Signalbus 41 zu, während jede ESD-Schutz-Vorrichtung 19 das weitere ESD-Signal 6' von dem ESD-Signalbus 41 abgreift. Tritt der ESD-Fall zwischen V_{DD1} und V_{SS} oder zwischen V_{DD2} und V_{SS} auf, so wird dies von den Ansteuerungsvorrichtungen 7 erfasst, welche eine entsprechende Information mit Hilfe des weiteren ESD-Signals 6' an die ESD-Schutz-Vorrichtungen 19 übermitteln. Daraufhin kommen die ESD-Schutz-Vorrichtungen 19 in einen niederohmigen Zustand und leiten die Überspannung ab, bevor die zu schützende nicht dargestellte Schaltung Schaden erleidet.

Während bei der in Fig. 9 dargestellten Ausführungsform des ESD-Schutz-Systems 55 nur ESD-Schutz-Anordnungen bzw. ESD-Schutz-Vorrichtungen 19, welche jeweils zwischen zwei Leitungen angeordnet sind, dargestellt sind, kann das ESD-Schutz-System 55 selbstverständlich auch eine oder mehrere ESD-Schutz-Anordnungen aufweisen, welche zwischen V_{DD1} und V_{DD2} sowie V_{SS} angeordnet sind, so dass eine solche ESD-Schutz-Anordnung dann im ESD-Fall sowohl für eine niederohmige Verbindung zwischen V_{DD1} und V_{SS} als auch V_{DD2} und Vss sorgt.

Die Ansteuerungsvorrichtungen 7 und die ESD-Schutz-Vorrichtungen 19 bzw. ESD-Schutz-Anordnungen können irgendwo in dem Versorgungsnetz, welches aus den V_{DD1**,**} V_{DD2} und Vss tragenden Leitungen besteht, angeordnet sein. Dabei ist eine Signalstärke des auf dem ESD-Signalbus 41 befindlichen weiteren ESD-Signals 6', welches zur Ansteuerung der ESD-Schutz-Anordnungen bzw. ESD-Schutz-Vorrichtungen 19 notwendig ist, und eine Treiberfähigkeit der Ansteuerungsvorrichtungen 7, d. h. eine Signalstärke, mit der die jeweilige Ansteuerungsvorrichtung 7 das weitere ESD-Signal 6' erzeugt, zu berücksichtigen. Die Ansteuerungsvorrichtungen 7 sollten dabei dort angeordnet sein, wo sich ein bzgl. ESD empfindlicher Schaltungsteil der zu schützenden Schaltung befindet.

In Fig. 10 ist ein weiteres Ausführungsbeispiel eines ESD-Schutz-Systems 56 dargestellt. Dabei schützt das ESD-Schutz-System 56 zum einen einen Ein/Ausgabeanschluss 42 einer nicht bzgl. Überspannung toleranten Schaltung und zum anderen einen Ein/Ausgabeanschluss 43 einer bzgl. Überspannung toleranten Schaltung. Dabei wird unter einer nicht bzgl. Überspannung toleranten Schaltung eine Schaltung verstanden, welche nicht derart ausgelegt ist, dass sie ein Potenzial an ihrem Ein/Ausgabeanschluss verkraftet, welches höher als ihr Versorgungsspannungspotenzial (V_{DD}) ist. Im Gegensatz dazu verkraftet eine bzgl. Überspannung tolerante Schaltung ein Potenzial an ihrem Ein/Ausgabeanschluss, welches größer als ihr Versorgungsspannungspotenzial (V_{DD}) ist.

Das ESD-Schutz-System 56 umfasst eine Ansteuerungsvorrichtung 7, zwei ESD-Schutz-Vorrichtungen 19, einen ESD-Signalbus 41 und einen floatenden Bus 44. Zwischen V_{SS} und dem Anschluss 42 und dem Anschluss 42 und V_{DD} ist jeweils eine Diode 3 in Flussrichtung geschaltet, so dass, wenn ein an dem Anschluss 42 anliegendes Potenzial zwischen V_{SS} und V_{DD} liegt, kein Stromfluss durch die Dioden 3 zu verzeichnen ist. Des Weiteren ist ein NFET-Treibertransistor 31 zwischen V_{SS} und dem Anschluss 42 und ein PFET-Treibertransistor 32 zwischen dem Anschluss 42 und V_{DD} angeschlossen. Diese beiden Treibertransistoren 31, 32 treten abwechselnd in Aktion, wenn der Anschluss 42 als Ausgang betrieben wird. Der Ein/Ausgabeanschluss 43 unterscheidet sich von dem Ein/Ausgabeanschluss 42 nur dadurch, dass die obere Diode 3 nicht mit V_{DD} sondern mit dem floatenden Bus 44 verbunden ist.

Tritt nun an dem Anschluss 42 eine Überspannung bzw. ein Potenzial auf, welches größer als V_{DD} ist, so wird die obere Diode 3 leitend, so dass die an dem Anschluss 42 anliegende Überspannung auf die V_{DD} tragende Leitung abgeleitet wird. Diese Überspannung auf der V_{DD} tragenden Leitung erfasst die Ansteuerungsvorrichtung 7, welche das weitere ESD-Signal 6' entsprechend setzt. Daraufhin kommen beide ESD-Schutz-Vorrichtungen 19 in den niederohmigen Zustand, wodurch die Überspannung auf der V_{DD} tragenden Leitung von der linken ESD-Schutz-Vorrichtung auf die V_{SS} tragende Leitung abgeleitet wird. Bei dem Anschluss 43, welcher zu einer bzgl. Überspannung toleranten Schaltung (nicht dargestellt) gehört, wird eine an dem Anschluss 43 anliegende Überspannung über die obere Diode 3 auf den floatenden Bus 44 abgeleitet. Auch diese Überspannung wird von der Ansteuerungsvorrichtung 7 erfasst, welche wiederum das weitere ESD-Signal 6' entsprechend setzt, wodurch die Überspannung auf die V_{SS} tragende Leitung durch die rechte ESD-Schutz-Vorrichtung 19 abgeleitet wird.

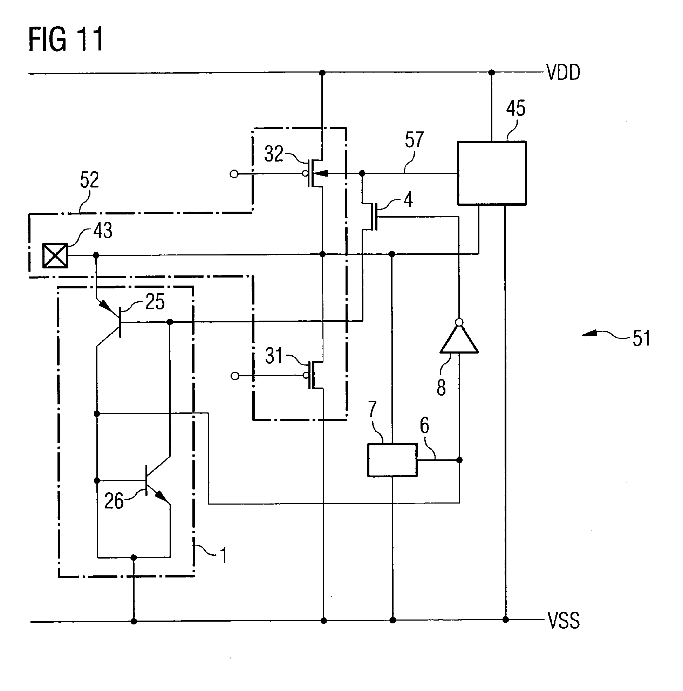

In Fig. 11 ist eine ESD-Schutz-Vorrichtung 51 dargestellt, welche eine Wannensteuerschaltung 45 umfasst. Dabei umfasst die ESD-Schutz-Vorrichtung 51 eine Ein/Ausgabe-Anordnung 52 eine Thyristor-Schaltung 1, eine Ansteuerungsvorrichtung 7, einen NMOS-Transistor 4 und eine Wannensteuerschaltung 45. Die Ein/Ausgabe-Anordnung 52 weist einen Ein/Ausgabeanschluss 43, einen PFET-Treibertransistor 32, welcher eine Verbindung zwischen dem Anschluss 43 und der Versorgungsspannung V_{DD} schaltet, und einen NFET-Treibertransistor 31, welcher eine Verbindung zwischen dem Anschluss 43 und der Versorgungsspannung V_{SS} schaltet, auf. Die Thyristor-Schaltung 1 besteht aus einem PNP-Transistor 25 und einem NPN-Transistor 26, wobei der Emitter des PNP-Transistors 25 mit dem Anschluss 43 verbunden ist. Der Kollektor des PNP-Transistors 25 ist mit der Basis des NPN-Transistors 26, dem Emitter des NPN-Transistors 26, mit V_{SS} sowie mit dem ESD-Signal, welches von der Ansteuerungsvorrichtung 7 ausgegeben wird, verbunden. Die Wannensteuerschaltung 45 ist mit dem Anschluss 43, mit V_{DD} und mit V_{SS} verbunden und gibt ausgangsseitig ein Wannensteuersignal 57 aus, welches als Potenzial das Maximum von V_{DD} und einem an dem Anschluss 43 anliegenden Potenzial annimmt. Das Wannensteuersignal 57 steuert zum einen ein Wannenpotenzial des PFET-Treibertransistors 32 und ist zum anderen über den NMOS-Transistor 4 und den n-Wannen-Widerstand (nicht dargestellt) mit der Basis des PNP-Transistors 25 und dem Kollektor des NPN-Transistors 26 verbunden.

Die in Fig. 11 dargestellte ESD-Schutz-Vorrichtung wird insbesondere bei Halbleiterschaltungen eingesetzt, bei denen es nicht erlaubt ist, unter normalen Betriebszuständen die Wannenkontakte direkt mit der Versorgungsspannungsleitung V_{DD} zu verbinden. Dies gilt beispielsweise für n-Wannen eines Ein/Ausgabeanschlusses einer bzgl. Überspannung toleranten Schaltung. Bei solchen Halbleiterschaltungen ist es nach dem Stand der Technik bekannt, das Wannenpotenzial der Treibertransistoren durch eine bestimmte Wannensteuerschaltung einzustellen. Bei der in Fig. 11 dargestellten ESD-Schutz-Vorrichtung 51 wird diese Wannensteuerschaltung 45 nun zusätzlich verwendet, um das Potenzial der n-Wanne der Thyristor-Schaltung 1 einzustellen, wobei zwischen das Wannensteuersignal 57 und den n-Wannenkontakt der Thyristor-Schaltung 1 der NMOS-Transistor 4 geschaltet ist, um den n-Wannen-Widerstand der Thyristor-Schaltung 1 zu verändern bzw. zu schalten, wie es aus vorab beschriebenen Ausführungsformen bekannt ist.

## Patentansprüche

1. ESD-Schutz-Vorrichtung, welche zwischen eine erste Leitung (V_{DD}) und eine zweite Leitung (V_{SS}) zu schalten ist und einen mit der ersten Leitung (V_{DD}) einerseits und der zweiten Leitung (V_{SS}) andererseits zu verbindenden Thyristor (1) umfasst,
**dadurch gekennzeichnet,**
**dass** der ESD-Schutz-Vorrichtung (19) ein ESD-Signal (6) zuführbar ist, welches für einen Fall, dass zwischen der ersten (V_{DD}) und der zweiten (V_{SS}) Leitung ein ESD-Fall auftritt, einen anderen Wert aufweist als bei einem Nicht-ESD-Fall, welcher dann vorliegt, wenn der ESD-Fall nicht vorliegt,
**dass** die ESD-Schutz-Vorrichtung (19) derart ausgestaltet ist, dass, wenn die ESD-Schutz-Vorrichtung (19) mittels des ESD-Signals (6) den ESD-Fall erfasst, die ESD-Schutz-Vorrichtung einen Widerstand (4, 11; 5, 12) der ESD-Schutz-Vorrichtung (19) im Vergleich zum Nicht-ESD-Fall erhöht.

2. ESD-Schutz-Vorrichtung nach Anspruch 1,
**dadurch gekennzeichnet,**
**dass** der Thyristor (1) einen ersten Anschluss (27), welcher mit der ersten Leitung (V_{DD}) verbindbar ist, und einen zweiten Anschluss (28), welcher mit der zweiten Leitung (V_{SS}) verbindbar ist, umfasst,
**dass** die ESD-Schutz-Vorrichtung einen Schalter (4; 5) umfasst, welcher zwischen dem ersten Anschluss (27) und einem ersten Punkt (13) innerhalb des Thyristors (1) oder zwischen dem zweiten Anschluss (28) und einem zweiten Punkt (14) innerhalb des Thyristors (1) angeordnet ist, und
**dass** die ESD-Schutz-Vorrichtung derart ausgestaltet ist, dass die ESD-Schutz-Vorrichtung den Schalter (4; 5) derart ansteuert, dass der Schalter (4; 5) im ESD-Fall geöffnet und im Nicht-ESD-Fall geschlossen ist.

3. ESD-Schutz-Vorrichtung nach Anspruch 2,
**dadurch gekennzeichnet,**
**dass** der Thyristor (1) einen ersten Transistor (25) eines ersten Leitungstyps und einen zweiten Transistor (26) eines zweiten zum ersten Leitungstyp unterschiedlichen Leitungstyps umfasst,
**dass** der erste Anschluss (27) des Thyristors (1) mit einem einem Emitter gleichzusetzenden ersten Anschluss des ersten Transistors (25) und über einen Schalter (4) der ESD-Schutz-Vorrichtung (19) mit dem Steuereingang des ersten Transistors (25) und einem einem Kollektor gleichzusetzenden ersten Anschluss des zweiten Transistors (26) verbunden ist,
**dass** ein einem Kollektor gleichzusetzender zweiter Anschluss des ersten Transistors (25) mit dem Steuereingang des zweiten Transistors (26), dem zweiten Anschluss (28) des Thyristors (1) und einem einem Emitter gleichzusetzenden zweiten Anschluss des zweiten Transistors (28) verbunden ist,
**dass** die ESD-Schutz-Vorrichtung (19) derart ausgestaltet ist, dass die ESD-Schutz-Vorrichtung (19) im ESD-Fall den Schalter (4; 5) mittels des ESD-Signals (6) öffnet sowie den Thyristor (1) mittels des ESD-Signals (6) zur Durchschaltung ansteuert und im Nicht-ESD-Fall den Schalter (4) mittels des ESD-Signals (6) schließt.

4. ESD-Schutz-Vorrichtung nach Anspruch 2,
**dadurch gekennzeichnet,**
**dass** der Thyristor (1) einen ersten Transistor (25) eines ersten Leitungstyps und einen zweiten Transistor (26) eines zweiten zum ersten Leitungstyp unterschiedlichen Leitungstyps sowie einen ersten Anschluss (27), welcher mit der ersten Leitung (V_{DD}) verbindbar ist, und einen zweiten Anschluss (28), welcher mit der zweiten Leitung (V_{SS}) verbindbar ist, umfasst,
**dass** der erste Anschluss (27) des Thyristors (1) mit einem einem Emitter gleichzusetzenden ersten Anschluss des ersten Transistors (25), mit dem Steuereingang des ersten Transistors (25) und einem einem Kollektor gleichzusetzenden ersten Anschluss des zweiten Transistors (26) verbunden ist,
**dass** der zweite Anschluss (28) des Thyristors (1) mit einem einem Emitter gleichzusetzenden zweiten Anschluss des zweiten Transistors (26) und über einen Schalter (5) der ESD-Schutz-Vorrichtung (19) mit einem einem Kollektor gleichzusetzenden zweiten Anschluss des ersten Transistors (25) und mit dem Steuereingang des zweiten Transistors (26)verbunden ist,
**dass** die ESD-Schutz-Vorrichtung (19) derart ausgestaltet ist, dass die ESD-Schutz-Vorrichtung (19) im ESD-Fall den Schalter (5) mittels des ESD-Signals (6) öffnet sowie den Thyristor (1) mittels des ESD-Signals (6) zur Durchschaltung ansteuert und im Nicht-ESD-Fall den Schalter (5) mittels des ESD-Signals (6) schließt.

5. ESD-Schutz-Vorrichtung nach einem der Ansprüche 2-4,
**dadurch gekennzeichnet,**
**dass** der Schalter ein Transistor (4; 5) ist.

6. ESD-Schutz-Vorrichtung nach Anspruch 5,
**dadurch gekennzeichnet,**
**dass** die ESD-Schutz-Vorrichtung (19) ein n+-Gebiet (61) aufweist, und
**dass** die ESD-Schutz-Vorrichtung (19) derart ausgestaltet ist, dass der Transistor (4) und der Thyristor (1) beide dieses n+-Gebiet (61) umfassen.

7. ESD-Schutz-Vorrichtung nach Anspruch 5 oder 6,
**dadurch gekennzeichnet,**
**dass** die ESD-Schutz-Vorrichtung (19) derart ausgestaltet ist, dass innerhalb eines p-Substrats (18) eine n-Wanne (15) von einer ersten p-Wanne (16') und einer zweiten p-Wanne (16) benachbart ist,
**dass** innerhalb der ersten p-Wanne (16') ein erstes n+-Gebiet (60), welches mit der ersten Leitung (V_{DD}) verbindbar ist, vorhanden ist, dass ein zweites n+-Gebiet (61) sowohl innerhalb der ersten p-Wanne (16') als auch innerhalb der n-Wanne (15) angeordnet ist, wobei zwischen dem ersten (60) und dem zweiten (61) n+-Gebiet das invertierte ESD-Signal (6) zuführbar ist,
**dass** in der n-Wanne (15) isoliert zu dem zweiten n+-Gebiet (61) ein erstes p+-Gebiet (63) vorhanden ist, welches mit der ersten Leitung (V_{DD}) verbindbar ist,
**dass** in der zweiten p-Wanne (16) ein drittes n+-Gebiet (64), welches mit der zweiten Leitung (V_{SS}) verbindbar ist, ein von dem dritten n+-Gebiet (64) isoliertes zweites p+-Gebiet (65), welches mit dem ESD-Signal (6) verbindbar ist, und ein von dem dritten n+-Gebiet (64) und von dem zweiten p+-Gebiet (65) isoliertes drittes p+Gebiet (66), welches mit der zweiten Leitung (V_{SS}) verbindbar ist, vorhanden ist.

8. ESD-Schutz-Vorrichtung nach Anspruch 5 oder 6,
**dadurch gekennzeichnet,**
**dass** die ESD-Schutz-Vorrichtung (19) derart ausgestaltet ist, dass innerhalb eines p-Substrats (18) eine n-Wanne (15) von einer ersten p-Wanne (16') und einer zweiten p-Wanne (16) benachbart ist,
**dass** innerhalb der ersten p-Wanne (16') ein erstes n+-Gebiet (60), welches mit der ersten Leitung (V_{DD}) verbindbar ist, vorhanden ist, dass ein von dem ersten n+-Gebiet (60) isoliertes zweites n+-Gebiet (61) sowohl innerhalb der ersten p-Wanne (16') als auch innerhalb der n-Wanne (15) angeordnet ist, welchem das invertierte ESD-Signal (6) zuführbar ist, wobei zwischen dem ersten (60) und dem zweiten (61) n+-Gebiet das invertierte ESD-Signal (6) zuführbar ist,
**dass** in der n-Wanne (15) isoliert zu dem zweiten n+-Gebiet (61) ein erstes p+-Gebiet (63) vorhanden ist, welches mit der ersten Leitung (V_{DD}) verbindbar ist, dass in der zweiten p-Wanne (16) ein drittes n+-Gebiet (64), welches mit der zweiten Leitung (V_{SS}) verbindbar ist, und ein von dem dritten n+-Gebiet (64) isoliertes zweites p+-Gebiet (66), welches mit der zweiten Leitung (VSS) verbindbar ist, vorhanden ist.

9. ESD-Schutz-Vorrichtung nach Anspruch 5,
**dadurch gekennzeichnet,**
**dass** die ESD-Schutz-Vorrichtung (19) ein p+-Gebiet (66) aufweist, und
**dass** die ESD-Schutz-Vorrichtung (19) derart ausgestaltet ist, dass der Transistor (5) und der Thyristor (1) beide dieses p+-Gebiet (66) umfassen.

10. ESD-Schutz-Vorrichtung nach Anspruch 5 oder 9,
**dadurch gekennzeichnet,**
**dass** die ESD-Schutz-Vorrichtung (19) derart ausgestaltet ist, dass innerhalb eines p-Substrats (18) eine p-Wanne (16) von einer ersten n-Wanne (15) und einer zweiten n-Wanne (15') benachbart ist,
**dass** innerhalb der ersten n-Wanne (15) ein erstes n+-Gebiet (61), welches mit der ersten Leitung (V_{DD}) verbindbar ist, ein von dem ersten n+-Gebiet (61) isoliertes zweites n+-Gebiet (62), welchem das invertierte ESD-Signal (6) zuführbar ist, und ein von dem ersten (61) und zweiten (62) n+-Gebiet isoliertes erstes p+-Gebiet (63), welches mit der ersten Leitung (V_{DD}) verbindbar ist, vorhanden ist, dass innerhalb der p-Wanne (16) ein drittes n+-Gebiet (64), welches mit der zweiten Leitung (V_{SS}) verbindbar ist, vorhanden ist und dass ein von dem dritten n+-Gebiet (64) isoliertes zweites p+-Gebiet (66) sowohl innerhalb der p-Wanne (16) als auch innerhalb der zweiten n-Wanne (15') angeordnet ist, dass innerhalb der zweiten n-Wanne (15') ein von dem zweiten p+-Gebiet (66) isoliertes drittes p+-Gebiet (67), welches mit der zweiten Leitung (V_{SS}) verbindbar ist, vorhanden ist, wobei zwischen dem zweiten (66) und dem dritten (67) p+-Gebiet das ESD-Signal (6) zuführbar ist.

11. ESD-Schutz-Vorrichtung nach Anspruch 5 oder 9,
**dadurch gekennzeichnet,**
**dass** die ESD-Schutz-Vorrichtung (19) derart ausgestaltet ist, dass innerhalb eines p-Substrats (18) eine p-Wanne (16) von einer ersten n-Wanne (15) und einer zweiten n-Wanne (15') benachbart ist,
**dass** innerhalb der ersten n-Wanne (15) ein erstes n+-Gebiet (61), welches mit der ersten Leitung (V_{DD}) verbindbar ist, und ein von dem ersten n+-Gebiet (61) isoliertes erstes p+-Gebiet (63), welches mit der ersten Leitung (V_{DD}) verbindbar ist, vorhanden ist, dass innerhalb der p-Wanne (16) ein zweites n+-Gebiet (64), welches mit der zweiten Leitung (V_{SS}) verbindbar ist, vorhanden ist und dass ein von dem zweiten n+-Gebiet (64) isoliertes zweites p+-Gebiet (66) sowohl innerhalb der p-Wanne (16) als auch innerhalb der zweiten n-Wanne (15') angeordnet ist, welchem das ESD-Signal (6) zuführbar ist, und dass innerhalb der zweiten n-Wanne (15') ein drittes p+-Gebiet (67), welches mit der zweiten Leitung (Vₛₛ) verbindbar ist, vorhanden ist, wobei zwischen dem zweiten (66) und dem dritten (67) p+-Gebiet das ESD-Signal (6) zuführbar ist.

12. ESD-Schutz-Vorrichtung nach einem der Ansprüche 1-11,
**dadurch gekennzeichnet,**
**dass** das Potenzial der ersten Leitung (V_{DD}) über dem Potenzial der zweiten Leitung (V_{SS}) liegt.

13. ESD-Schutz-Vorrichtung nach einem der Ansprüche 1-12,
**dadurch gekennzeichnet, dass** die erste Leitung (V_{DD}) und die zweite Leitung (Vₛₛ) Versorgungsspannungsleitungen sind.

14. ESD-Schutz-Vorrichtung nach einem der Ansprüche 1-13,
**dadurch gekennzeichnet,**
**dass** die ESD-Schutz-Vorrichtung (20) eine Ansteuerungsvorrichtung (7) umfasst, dass die Ansteuerungsvorrichtung (7) derart ausgestaltet ist, dass die Ansteuerungsvorrichtung (7) den ESD-Fall zwischen der ersten (V_{DD}) und der zweiten Leitung (V_{SS}) erfassen kann und das ESD-Signal (6) erzeugt.

15. ESD-Schutz-Vorrichtung nach Anspruch 14,
**dadurch gekennzeichnet,**
**dass** die ESD-Schutz-Vorrichtung (51) eine Ein/Ausgabe-Anordnung (52) mit einem Ein/Ausgabe-Anschluss (43), einem ersten (32) und einem zweiten Treibertransistor (31) und eine Steuerschaltung (45) umfasst,
**dass** die Steuerschaltung (45) derart ausgestaltet ist, dass am Ausgang der Steuerschaltung (45) das Maximum aus dem Potenzial der
ersten Leitung (V_{DD}) und dem Potenzial des Ein/AusgabeAnschlusses (43) abgreifbar ist,
**dass** die ESD-Schutz-Vorrichtung (51) derart ausgestaltet ist, dass die erste Leitung (V_{DD}) über den ersten Treibertransistor (32) mit dem ersten Anschluss des ersten Transistors (25) verbindbar ist, dass der Ausgang der Steuerschaltung (45) mit einem Wannenkontakt des ersten Treibertransistors (32) und über den Schalter (4) mit dem Steuereingang des ersten Transistors (25) und dem ersten Anschluss des zweiten Transistors (26) verbunden ist, dass der Ein/Ausgabe-Anschluss (43) mit dem ersten Anschluss des ersten Transistors (25) verbunden ist,
**dass** die Ansteuerungsvorrichtung (7) derart ausgestaltet ist, dass die Ansteuerungsvorrichtung (7) den ESD-Fall zwischen dem Ein/Ausgabe-Anschluss (43) und der zweiten Leitung (V_{SS}) erfassen kann und das ESD-Signal (6) erzeugt, und
**dass** der Ein/Ausgabe-Anschluss (43) über den zweiten Treibertransistor (31) mit der zweiten Leitung (V_{SS}) verbindbar ist.

16. ESD-Schutz-Anordnung,
**dadurch gekennzeichnet,**
**dass** die ESD-Schutz-Anordnung (53) mindestens eine ESD-Schutz-Vorrichtung (19) nach einem der Ansprüche 1-13 umfasst,
**dass** die ESD-Schutz-Anordnung (53) zwischen mindestens einer ersten Leitung (V_{DD1}, V_{DD2}) und der zweiten Leitung (Vss) angeordnet ist, wobei die Anzahl der mindestens einen ersten Leitung (V_{DD1}, V_{DD2}) gleich der Anzahl der mindestens einen ESD-Schutz-Vorrichtung (19) ist,
**dass** zwischen jeder der mindestens einen ersten Leitung (V_{DD1}, V_{DD2}) und der zweiten Leitung (V_{SS}) jeweils eine der mindestens einen ESD-Schutz-Vorichtungen (19) angeordnet ist, dass der ESD-Schutz-Anordnung (53) ein weiteres ESD-Signal (6') zuführbar ist, welches für einen Fall, dass zwischen irgendeiner der mindestens einen ersten Leitung (V_{DD1}, V_{DD2}) und der zweiten Leitung (V_{SS}) der ESD-Fall auftritt, einen anderen Wert aufweist als wenn zwischen keiner der mindestens einen ersten Leitung (V_{DD1}, V_{DD2}) und der zweiten Leitung (V_{SS}) der ESD-Fall auftritt, dass die ESD-Schutz-Anordnung (53) derart ausgestaltet ist, dass die ESD-Schutz-Anordnung (53) jeder ESD-Schutz-Vorrichtung (19) das weitere ESD-Signal (6') als das ESD-Signal (6) der jeweiligen ESD-Schutz-Vorrichtung (19) zuführt.

17. ESD-Schutz-Anordnung nach Anspruch 16,
**dadurch gekennzeichnet,**
**dass** die ESD-Schutz-Anordnung (53) genau eine erste ESD-Schutz-Vorrichtung und eine zweite ESD-Schutz-Vorrichtung umfasst.

18. ESD-Schutz-Anordnung nach Anspruch 17,
**dadurch gekennzeichnet,**
**dass** die ESD-Schutz-Anordnung (53) mindestens ein n+-Gebiet (A) und mindestens ein p+-Gebiet (B) umfasst, und
**dass** die ESD-Schutz-Anordnung (53) derart ausgestaltet ist, dass der Thyristor der ersten ESD-Schutz-Vorrichtung und der Thyristor der zweiten ESD-Schutz-Vorrichtung beide das mindestens eine n+-Gebiet (A) und/oder das mindestens eine p+-Gebiet (B) umfassen.

19. ESD-Schutz-Anordnung nach Anspruch 17 oder 18,
**dadurch gekennzeichnet,**
**dass** die ESD-Schutz-Anordnung (53) derart ausgestaltet ist, dass ein Gebiet (B) des ersten Anschlusses des ersten Transistors der ersten ESD-Schutz-Vorrichtung gleich einem Gebiet (B) des ersten Anschlusses des ersten Transistors der zweiten ESD-Schutz-Vorrichtung ist und/oder dass ein Gebiet (B) des Steuereingangs des zweiten Transistors der ersten ESD-Schutz-Vorrichtung gleich einem Gebiet (B) des Steuereingangs des zweiten Transistors der zweiten ESD-Schutz-Vorrichtung ist.

20. ESD-Schutz-Anordnung nach einem der Ansprüche 17-19,
**dadurch gekennzeichnet,**
**dass** die ESD-Schutz-Anordnung (53) zwischen einer ersten (V_{DD1}) und einer weiteren ersten Leitung (V_{DD2}) und der zweiten Leitung (V_{SS}) angeordnet ist,
**dass** die ESD-Schutz-Anordnung (53) derart ausgestaltet ist, dass in einer Richtung von oben nach unten
(i) oben eine erste n-Wanne (I) und unterhalb der ersten n-Wanne durch eine Anordnung getrennt eine zweite n-Wanne (H) vorhanden sind,
(ii) dass oberhalb der ersten n-Wanne (I) ein erstes n+-Gebiet (K) vorhanden ist, welches mit der weiteren ersten Leitung (V_{DD2}) verbindbar ist,
(iii) dass unterhalb des ersten n+-Gebietes (K) ein zweites n+Gebiet (E) vorhanden ist, welches mit einem bestimmten Anteil innerhalb der ersten n-Wanne (I) und mit dem Rest außerhalb der ersten n-Wanne (I) liegt und welches von dem ersten n+Gebiet (K) durch ein erstes Polysilizium-Gate-Gebiet (L), dem das invertierte weitere ESD-Signal (6') zuführbar ist, getrennt ist,
(iv) dass innerhalb der ersten n-Wanne (I) unterhalb getrennt von dem zweiten n+-Gebiet (E) ein erstes p+-Gebiet (G) vorhanden ist, welches mit der weiteren ersten Leitung (V_{DD2}) verbindbar ist,
(v) dass unterhalb der zweiten n-Wanne (H) ein drittes n+-Gebiet (J) vorhanden ist, welches mit der einen ersten Leitung (V_{DD1}) verbindbar ist,
(vi) dass oberhalb des dritten n+-Gebietes (J) ein viertes n+Gebiet (D) vorhanden ist, welches mit einem bestimmten Anteil innerhalb der zweiten n-Wanne (H) und mit dem Rest außerhalb der zweiten n-Wanne (H) liegt und welches von dem dritten n+Gebiet (J) durch ein zweites Polysilizium-Gate-Gebiet (M), dem das invertierte weitere ESD-Signal (6') zuführbar ist, getrennt ist,
(vii) dass innerhalb der zweiten n-Wanne (H) oberhalb getrennt von dem vierten n+-Gebiet (D) ein zweites p+-Gebiet (F) vorhanden ist, welches mit der einen ersten Leitung (V_{DD1}) verbindbar ist,
(viii)dass die Anordnung mindestens ein drittes p+-Gebiet (B), welches mit dem weiteren ESD-Signal (6') verbindbar ist, und mindestens ein fünftes n+-Gebiet (A) umfasst, welches mit der zweiten Leitung (V_{SS}) verbindbar ist.

21. ESD-Schutz-Anordnung nach Anspruch 20,
**dadurch gekennzeichnet,**
**dass** das mindestens eine dritte p+-Gebiet (B) und das mindestens eine fünfte n+-Gebiet (A) nebeneinander in einer Richtung von links nach rechts angeordnet sind.

22. ESD-Schutz-Anordnung nach einem der Ansprüche 16-21,
**dadurch gekennzeichnet,**
**dass** das Potenzial jeder ersten Leitung (V_{DD1}, V_{DD2}) über dem Potenzial der zweiten Leitung (V_{SS}) liegt.

23. ESD-Schutz-Anordnung nach einem der Ansprüche 16-22,
**dadurch gekennzeichnet,**
**dass** jede erste Leitung (V_{DD1}, V_{DD2}) und die zweite Leitung (V_{SS}) Versorgungsspannungsleitungen sind.

24. ESD-Schutz-Anordnung nach einem der Ansprüche 16-23,
**dadurch gekennzeichnet,**
**dass** die ESD-Schutz-Anordnung (54) eine Ansteuerungsvorrichtung (7) umfasst,
**dass** die Ansteuerungsvorrichtung (7) derart ausgestaltet ist, dass die Ansteuerungsvorrichtung (7) den ESD-Fall zwischen irgendeiner der mindestens einen ersten Leitung (V_{DD1}, V_{DD2}) und der zweiten Leitung (Vₛₛ) erfassen kann und das weitere ESD-Signal (6') erzeugt.

25. ESD-Schutz-Anordnung nach Anspruch 24,
**dadurch gekennzeichnet,**
**dass** die ESD-Schutz-Anordnung (54) zwischen zwei ersten Leitungen (V_{DD1}, V_{DD2}) und der zweiten Leitung (V_{SS}) angeordnet ist,
**dass** die Ansteuerungsvorrichtung (7) eine Anzahl von in Serie geschalteten Dioden (3), einen Transistor (4) und einen Widerstand (9) umfasst,
**dass** die Dioden (3) in Flussrichtung zwischen einer der ersten Leitungen (V_{DD1}) und einem ersten Anschluss des Widerstands (9) angeschlossen sind,
**dass** der Transistor (4) zwischen einer weiteren der ersten Leitungen (V_{DD2}) und dem ersten Anschluss des Widerstands (9) angeschlossen ist,
**dass** der Steueranschluss des Transistors (4) und ein zweiter Anschluss des Widerstands (9) mit der zweiten Leitung (Vₛₛ) verbunden sind, und
**dass** am ersten Anschluss des Widerstands das weitere ESD-Signal (6') abgreifbar ist.

26. ESD-Schutz-System,
**dadurch gekennzeichnet,**
**dass** das ESD-Schutz-System (55) mindestens eine ESD-Schutz-Anordnung (53) nach einem der Ansprüche 16-23 umfasst,
**dass** das ESD-Schutz-System (55) zwischen der mindestens einen ersten Leitung (V_{DD1}, V_{DD2}; V_{DD}, 44) und der zweiten Leitung (Vss) angeordnet ist,
**dass** mindestens eine ESD-Schutz-Anordnung der mindestens einen ESD-Schutz-Anordnung des ESD-Schutz-Systems (55) zwischen jeder der mindestens einen ersten Leitung (V_{DD1}, V_{DD2}; V_{DD}, 44) und der zweiten Leitung (V_{SS}) angeordnet ist, und
**dass** jede ESD-Schutz-Anordnung (53) mit einem Bus (41) des ESD-Schutz-Systems gekoppelt ist, über welchen jeder ESD-Schutz-Anordnung (53) das weitere ESD-Signal (6') zugeführt wird.

27. ESD-Schutz-System nach Anspruch 26,
**dadurch gekennzeichnet,**
**dass** das ESD-Schutz-System (55) mindestens eine Ansteuerungsvorrichtung (7) umfasst,
**dass** jede Ansteuerungsvorrichtung (7) derart ausgestaltet ist, dass jede Ansteuerungsvorrichtung (7) den ESD-Fall zwischen irgendeiner der mindestens einen ersten Leitung (V_{DD1}, V_{DD2}; V_{DD}, 44) und der zweiten Leitung (V_{SS}) erfassen kann, das weitere ESD-Signal (6') erzeugt und auf den Bus (41) einspeist.

28. ESD-Schutz-System nach Anspruch 26 oder 27,
**dadurch gekennzeichnet,**
**dass** das ESD-Schutz-System (56) eine erste Ein/Ausgabe-Anordnung mit einem Ein/Ausgabe-Anschluss (42; 43), einem Treibertransistor (32), einer ersten Diode (3) und einer zweiten Diode (3) umfasst,
**dass** die erste Ein/Ausgabe-Anordnung derart ausgestaltet ist, dass der Ein/Ausgabe-Anschluss (42; 43) mit dem Anodenanschluss der ersten Diode (3) und mit dem Katodenanschluss der zweiten Diode (3) verbunden ist, dass der Ein/Ausgabe-Anschluss (42; 43) über den Treibertransistor (32) und der Katodenanschluss der ersten Diode (3) mit einer der mindestens einen ersten Leitung (V_{DD}; 44) und der Anodenanschluss der zweiten Diode (3) mit der zweiten Leitung (V_{SS}) verbindbar ist.

29. ESD-Schutz-System nach einem der Ansprüche 26-28,
**dadurch gekennzeichnet,**
**dass** die mindestens eine erste Leitung mindestens zwei erste Leitungen (V_{DD1}, V_{DD2}; V_{DD}), 44) aufweist,
**dass** das ESD-Schutz-System (56) eine zweite Ein/Ausgabe-Anordnung mit einem Ein/Ausgabe-Anschluss (42), einem Treibertransistor (32), einer ersten Diode (3) und einer zweiten Diode (3) umfasst,
**dass** die zweite Ein/Ausgabe-Anordnung derart ausgestaltet ist, dass der Ein/Ausgabe-Anschluss (43) mit dem Anodenanschluss der ersten Diode (3) und mit dem Katodenanschluss der zweiten Diode (3) verbunden ist, dass der Ein/Ausgabe-Anschluss (43) über den Treibertransistor (32) mit einer der mindestens einen ersten Leitung (V_{DD}), der Katodenanschluss der ersten Diode (3) mit einer weiteren der mindestens einen ersten Leitung (44) und der Anodenanschluss der zweiten Diode (3) mit der zweiten Leitung (V_{SS}) verbindbar ist.

30. ESD-Schutz-System nach Anspruch 29,
**dadurch gekennzeichnet,**
**dass** die weitere der mindestens einen ersten Leitung eine floatende Busleitung (44) des ESD-Schutz-Systems (56) ist.

31. Halbleiterschaltung, welche eine vor ESD zu schützende Schaltung und eine ESD-Schutz-Vorrichtung (19; 20; 51) nach einem der Ansprüche 1-15 zum Schutz der Schaltung umfasst.

32. Halbleiterschaltung, welche eine vor ESD zu schützende Schaltung und eine ESD-Schutz-Anordnung (53; 54) nach einem der Ansprüche 16-25 zum Schutz der Schaltung umfasst.

33. Halbleiterschaltung, welche eine vor ESD zu schützende Schaltung und ein ESD-Schutz-System (55; 56) nach einem der Ansprüche 26-30 zum Schutz der Schaltung umfasst.
